(19) Europäisches Patentamt
European Patent Office
Office européen des brevets

(11) Veröffentlichungsnummer: **0 035 969**
**B1**

(12) # EUROPÄISCHE PATENTSCHRIFT

(45) Veröffentlichungstag der Patentschrift: **13.02.85**

(21) Anmeldenummer: **81810070.3**

(22) Anmeldetag: **02.03.81**

(51) Int. Cl.⁴: **C 08 K 5/41**, C 08 K 5/43, C 08 F 2/50 // G03C1/68, G03F7/00 ,(C08F2/50, C08G59/68)

(54) **Zusammensetzung aus kationisch polymerisierbarem Material und einem Katalysator.**

(30) Priorität: **07.03.80 GB 8007893**
**19.07.80 GB 8023690**
**13.12.80 GB 8040003**

(43) Veröffentlichungstag der Anmeldung: **16.09.81 Patentblatt 81/37**

(45) Bekanntmachung des Hinweises auf die Patenterteilung: **13.02.85 Patentblatt 85/7**

(84) Benannte Vertragsstaaten: **BE CH DE FR GB IT LI NL**

(56) Entgegenhaltungen: **EP - A - 0 022 081**

(73) Patentinhaber: **CIBA-GEIGY AG, Postfach, CH-4002 Basel (CH)**

(72) Erfinder: **Green, George Edward, Dr., 18 Church Street, Stapleford Cambrigde CB2 5DS (GB)**
Erfinder: **Irving, Edward, Dr., 41, Swaffham Road, Burwell Cambrigde CB5 OAN (GB)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).



BUNDESDRUCKEREI BERLIN

**Beschreibung**

Vorliegende Erfindung betrifft Zusammensetzungen, die aus einem kationisch polymerisierbaren Material und einem Sulfoxoniumsalz bestehen.

Aus verschiedenen Gründen hat es sich als wünschenswert erwiesen, die Polymerisation organischer Materialien mittels aktinischer Strahlung zu induzieren. Bei Anwendung von Photopolymerisationsmethoden kann man beispielsweise die Verwendung organischer Lösungsmittel mit den damit verbundenen Risiken der Giftigkeit, Entflammbarkeit und Umweltverschmutzung und den Kosten der Lösungsmittelrückgewinnung vermeiden. Die Photopolymerisation ermöglicht es, daß nur definierte Stellen der Harzzusammensetzung, d. h. solche, die bestrahlt wurden, unlöslich gemacht werden, und gestattet somit die Herstellung von gedruckten Schaltungen und Druckplatten oder erlaubt es, die Verklebung von Substraten auf die erforderlichen Zonen zu beschränken. Bei Produktionsverfahren sind ferner Bestrahlungsmethoden häufig schneller als solche, die eine Erhitzung und nachfolgende Kühlstufe einschließen.

Es ist seit Jahren bekannt, daß gewisse aromatische Diazoniumsalze bei der Belichtung mit aktinischer Strahlung einer Zersetzung unterliegen und daß, wenn das Salz mit einer kationisch polymerisierbaren Substanz gemischt ist, die bei der Bestrahlung in situ erzeugte Lewis-säure dann eine Polymerisation induziert (siehe z. B. britische Patentschrift Mr. 1 321 263). Obwohl die Anwendung von aktinischer Strahlung die mit dem Einsatz von Hitze im Polymerisationsverfahren verbundenen Nachteile überwindet, sind die Diazoniumsalze nicht völlig befriedigend: die Topfzeit des Gemischs aus Diazoniumsalz und kationisch polymerisierbarer Substanz ist häufig zu kurz, insbesondere im Tageslicht, und zweitens entsteht Stickstoff bei der Freisetzung des Lewis-säurekatalysators, wobei die Gasentwicklung den Verfahrensbereich, in dem die Katalysatoren erfolgreich eingesetzt werden können, beschränkt.

Es wurden deshalb zahlreiche Vorschläge für den Ersatz dieser Diazoniumsalze durch andere Salze gemacht, die bei der Freisetzung eines Säurekatalysators unter Bestrahlung nicht auch Stickstoff entwickeln: die Oniumsalze des Schwefels und Jodoniumsalze wurden besonders intensiv studiert.

So ist es kürzlich aus der britischen Patentschrift Nr. 1 516 511 und der parallelen U.S. Patentschrift Nr. 4 058 401 bekannt geworden, daß ein Mono-1,2-epoxid, ein Epoxidharz (d. h. eine Substanz, die im Durchschnitt mehr als eine 1,2-Epoxidgruppe enthält) oder deren Gemisch mittels eines strahlungsempfindlichen aromatischen Oniumsalzes des Sauerstoffs, Schwefels, Selens oder Tellurs, das in einer Menge vorliegt, die fähig ist, die Polymerisation oder Härtung des Epoxids (bzw. Polyepoxids) durch Freisetzung eines Brønsted-säurekatalysators bei der Belichtung mit Strahlungsenergie zu bewirken, polymerisiert oder gehärtet werden kann. Die einzigen solchen, in der Patentschrift beschriebenen Salze entsprechen der Formel

$$[(R)_a(R^1)_b(R^2)_cX]_d^+ [MQ_e]^{(e-f)-} \qquad (I)$$

worin R einen einwertigen aromatischen Rest, $R^1$ eine Alkyl-, Cycloalkyl- oder substituierte Alkylgruppe, $R^2$ einen mehrwertigen aliphatischen oder aromatischen, eine heterocyclische oder kondensierte Ringstruktur bildenden Rest, X Sauerstoff, Schwefel, Selen oder Tellur, M ein Atom eines Metalls oder Nicht-metalls wie Antimon, Eisen, Zinn, Wismut, Aluminium, Gallium, Indium, Titan, Zirkon, Scandium, Vanadium, Chrom, Mangan, Bor, Phosphor oder Arsen, Q einen Halogenrest, a 0, 1, 2 oder 3, b 0, 1 oder 2, c 0 oder 1, wobei die Summe von $a+b+c$ 3 oder die Wertigkeit von X ist, und d $(e-f)$ bedeuten, f als ganze Zahl von 2 bis 7 die Wertigkeit von M ist und e größer als f und eine ganze Zahl bis 8 ist.

Kurz danach offenbarte derselbe Patentinhaber in der britischen Patentschrift Nr. 1 518 141 und auch in der dementsprechenden U.S. Patentschrift Nr. 4 058 400, daß monomere oder präpolymere, kationisch polymerisierbare organische Materialien, die frei von 1,2-Epoxidgruppen und unter Vinylmonomeren, Vinylpräpolymeren, cyclischen Äthern, cyclischen Estern, cyclischen Sulfiden, cyclischen Aminen und cyclischen Organosiliciumverbindungen ausgewählt sind, ebenfalls durch Belichtung mit Strahlungsenergie in Gegenwart einer wirksamen Menge eines strahlungsempfindlichen Oniumsalzes der oben angeführten Elemente der Gruppe VI A polymerisiert werden können. Die einzigen beschriebenen Oniumsalze sind ebenfalls diejenigen der obigen Formel I.

Ganz kürzlich offenbarte derselbe Patentinhaber in seiner U.S. Patentschrift Nr. 4 102 687, daß man die Härtung von Harnstoff/Formaldehydharzen, Melamin/Formaldehydharzen und Phenol/Formaldehydharzen durch Belichtung mit ultravioletter Strahlung in Gegenwart eines Oniumsalzes der Gruppe VI A auslösen kann, wobei die Härtung durch Erhitzen vervollständigt wird. Wiederum werden nur Oniumsalze der Formel I erwähnt.

Spätere Offenbarungen durch diesen Patentinhaber über Oniumsalze des Schwefels beschränkten sich auf Sulfoniumsalze.

So ist in der britischen Patentschrift Nr. 1 535 492 die Verwendung strahlungsempfindlicher Sulfoniumsalze von Arylsulfon-, Halogenoarylsulfon-, Alkylsulfon- und Halogenoalkylsulfonsäuren für die kationische Polymerisation von Epoxidharzen, Vinylmonomeren und -präpolymeren, cyclischen organischen Äthern, cyclischen organischen Estern, cyclischen organischen Sulfiden, cyclischen Aminen und cyclischen Organosiliciumverbindungen beschrieben.

Seine U.S. Patentschrift Nr. 4 139 385 offenbart die Verwendung von Sulfoniumsalzen und weiteren Salzen bei der Härtung von Polyolefinen mittels Polythiolen. Eine polyäthylenisch ungesättigte Verbindung wie Diallylphthalat, Diallylmaleinat oder Triallylcyanurat wird mit einem Polythiol wie Trimethylolpropan-trithioglykolat oder Pentaerythrit-tetra(3-merkaptopropionat) und z. B. Triphenylsulfoniumhexafluoroarsenat oder Triphenylsulfonium-tetrafluoroborat vermischt und dann mit Ultraviolettlicht belichtet. Die als Katalysatoren eingesetzten Salze entsprechen sämtlich der Formel

$$[(R)_a(R^1)_bI]^+ [MX_k]^{(k-m)-} \qquad (II)$$

oder

$$[(R)_c(R^2)_d(R^3)_eS]^+ [MX_k]^{(k-m)-} \qquad (III)$$

oder

$$[(R)_f(R^4)_g(R^5)_hZ]^+ [MX_k]^{(k-m)-} \qquad (IV)$$

worin R einen einwertigen aromatischen Rest, $R^1$ einen zweiwertigen aromatischen Rest, $R^2$ einen mehrwertigen aliphatischen oder aromatischen, eine heterocyclische oder kondensierte Ringstruktur bildenden Rest, $R^4$ einen Alkyl-, Alkoxy-, Cycloalkyl- oder substituierten Alkylrest, $R^5$ einen mehrwertigen, eine aromatische, heterocyclische oder kondensierte Ringstruktur bildenden Rest, M ein Metall- oder Nicht-metallatom, X einen Halogenrest und Z ein Stickstoff-, Phosphor-, Arsen-, Wismut- oder Antimonatom darstellen, a 0 oder 2, b 0 oder 1, wobei $a + b = 2$ oder die Wertigkeit von Jod, c 0 oder 3, d 0 oder 2 und e 0 oder 1 bedeuten, so daß $(c + d + e) = 3$ oder die Wertigkeit des Schwefels, f eine ganze Zahl von 0 bis 4, g 0, 1 oder 2 und h 0, 1 oder 2 sind, so daß $(f + g + h) = 4$ oder die Wertigkeit von Z, j $k-m$ bedeutet, m die Wertigkeit von M, nämlich 2 bis 7, und k eine ganze Zahl größer als 1 aber höchstens 8 sind.

Aus seiner deutschen Offenlegungsschrift Nr. 2 833 648 ist es bekannt, daß man Triarylsulfoniumsalze der Formel

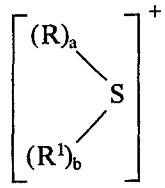 $[MQ_d]^-$ (V)

unter Bestrahlung zur Auslösung der Härtung einer aliphatisch ungesättigten Verbindung, die eine 1,2-Epoxidgruppe enthält, wie Glycidylacrylat, oder eines Gemischs aus einem Epoxidharz mit einer aliphatisch ungesättigten Substanz wie Methylmethacrylat, einem Polyester oder Styrol verwenden kann. In der Formel V bedeuten R eine gegebenenfalls substituierte aromatische Kohlenwasserstoff- oder heterocyclische Gruppe mit 6 bis 13 Kohlenstoffatomen, a 1 oder 3 und b 0 oder 1, S besitzt die Wertigkeit 3, die durch R allein oder eine Kombination von R und $R^1$ abgesättigt sein kann, stellen M ein Metall- oder Nichtmetallatom, Q einen Halogenrest und d 4, 5 oder 6 dar.

In seiner U.S. Patentschrift Nr. 4 136 102 sind verschiedene ein Hexafluorophosphat-, Hexafluoroarsenat- oder Hexafluoroantimontanion enthaltende Sulfoniumsalze sowie deren Verwendung bei der Härtung von Epoxidharzen beschrieben. Sie werden auch als nützlich zur Polymerisation einer Reihe nicht näher angegebener cyclischer organischer Verbindungen und cyclischer Organosiliciumverbindungen bezeichnet.

Aus seiner deutschen Offenlegungsschrift Nr. 2 730 725 ist auch die lichtinduzierte Härtung von ferner ein Polyvinylacetat enthaltenden Epoxidharzzusammensetzungen mittels aromatischer Oniumsalze bekannt. Die einzigen angegebenen Oniumsalze des Schwefels sind solche der Formel I.

In seiner U.S. Patentschrift Nr. 4 081 276 ist ein Verfahren zur Bildung von Photoresistabbildungen beschrieben, besonders zur Herstellung gedruckter Schaltungen, wobei eine Schicht eines Photoinitiators mit Strahlungsenergie belichtet und dann mit einem kationisch polymerisierbaren Material, z. B. einem Epoxidharz, in Berührung gebracht wird. Die einzigen angeführten Oniumsalze des Schwefels sind wiederum jene der obigen Formel I.

Ein anderer Patentinhaber hat in der belgischen Patentschrift Nr. 845 746 die Photopolymerisation von Gemischen aus einer Verbindung mit einer Epoxidfunktionalität von mehr als 1,5 Epoxidgruppen pro Molekül und einer Verbindung mit einer Hydroxylfunktionalität von mindestens eines unter Verwendung eines aromatischen Sulfoniumsalzes oder aromatischen Jodoniumsalzes als Katalysator beschrieben.

In U.S. Patentschrift Nr. 4 090 936 beschreibt dieser zweite Patentinhaber licht-härtbare flüssige Zusammensetzungen, die (a) eine organische Verbindung mit einer Durchschnittsepoxidfunktionalität im Bereich von etwa 1 bis 1,3, (b) etwa 3 bis 50 Gew.-%, berechnet auf das Gewicht von (a), eines organischen Polymeren, das mit (a) verträglich ist und einen Glasumwandlungspunkt im Bereich von

etwa −20°C bis 105°C aufweist, wobei sich dieses Polymer von mindestens einem Acrylat- oder Methacrylatmonomer oder einem Copolymer aus Styrol und Allylalkohol oder einem Polyvinylbutyralpolymer ableitet, und (c) einen aromatischen Komplexsalzphotoinitiator, der ein Oniumsalz eines Elements der Gruppe V A oder Gruppe VI A oder ein Haloniumsalz darstellt, enthalten. Die einzigen angegebenen Oniumsalze des Schwefels sind Sulfoniumsalze.

Eine weitere Offenbarung durch diesen zweiten Patentinhaber, U.S. Patentschrift Nr. 4 069 054, bezieht sich auf photopolymerisierbare Zusammensetzungen, die ein kationisch-polymerisierbares Monomer, eine aromatische Sulfoniumverbindung und ein aromatisches tertiäres Amin, aromatisches tertiäres Diamin oder eine aromatische polycyclische Verbindung als Sensibilisator enthalten.

Ein aromatisches Sulfoniumsalz, nämlich Triphenylsulfonium-hexafluorophosphat wurde schon industriell zur Photopolymerisation von Epoxidharzen eingesetzt.

Es wurde nun überraschend gefunden, daß man kationisch polymerisierbare Materialien mittels gewisser aromatischer Sulfoxoniumsalze photopolymerisieren kann.

Über die Sulfoniumsalze des Standes der Technik wird auch angegeben, daß sie Katalysatoren zur Heißhärtung oder Hitzepolymerisation seien. Die Sulfoxoniumsalze der erfindungsgemäßen Zusammensetzungen haben jedoch wenig oder keine Wirkung, wenn sie in Abwesenheit aktinischer Strahlung mit Verbindungen, die unter dem Einfluß eines kationischen Katalysators in höhermolekulares Material überführbar sind, erhitzt werden. So trat bei 48 Stunden Erhitzen auf 150°C keine Gelierung einer 2 Gewichtsteile Dimethylphenacylsulfoxonium-hexaflourophosphat und 100 Gewichtsteile eines Epoxidharzes (2,2-Bis-(4-glycidyloxyphenyl)-propan) enthaltenden Zusammensetzung ein. Daraus folgt, daß erfindungsgemäße Zusammensetzungen wünschenswert lange Topfzeiten besitzen, solange sie vor aktinischer Strahlung geschützt werden.

Im Gegensatz zu Sulfoniumsalze als Katalysatoren enthaltenden Zusammensetzungen des Standes der Technik setzen die erfindungsgemäßen Zusammensetzungen bei der Bestrahlung keine übelriechenden Merkaptane frei.

Es wurde ferner gefunden, daß Harnstoff/Formaldehydharze, entgegen der Erwartung nach den Lehren der U.S. Patentschrift Nr. 4 102 687, bei Bestrahlung in Gegenwart eines in den erfindungsgemäßen Zusammensetzungen eingesetzten Sulfoxoniumsalzes gehärtet werden können, ohne daß Wärmezufuhr nötig wäre.

Gegenstand dieser Erfindung sind demnach Zusammensetzungen, welche gekennzeichnet sind durch

(a) eine Verbindung bzw. ein Gemisch von Verbindungen, die unter dem Einfluß eines kationischen Katalysators in höhermolekulares Material überführbar sind, und
(b) eine katalytische Menge eines Sulfoxoniumsalzes der Formel

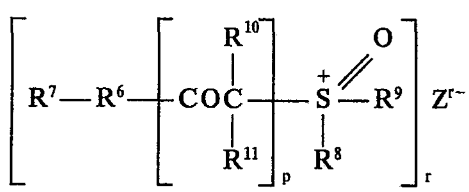

(VI)

worin p Null oder 1 bedeutet, $R^6$ eine Arylen- oder Aralkylengruppe mit 4 bis 25 Kohlenstoffatomen, die über eines ihrer Kohlenstoffatome bei p = Null direkt an das angegebene Schwefelatom oder bei p = 1 an das angegebene Carbonylkohlenstoffatom gebunden ist, darstellt, $R^7$ für ein Wasserstoffatom oder eine Gruppe der Formel

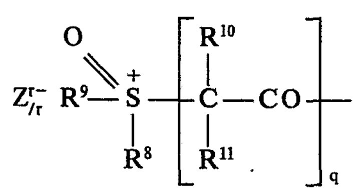

(VII)

steht, $R^8$ eine Alkylgruppe mit 1 bis 18 und vorzugsweise 1 bis 12 Kohlenstoffatomen, eine Alkenylgruppe mit 2 bis 6 Kohlenstoffatomen, eine Cycloalkylgruppe mit 3 bis 6 Kohlenstoffatomen, eine Cycloalkylalkylgruppe mit 4 bis 8 Kohlenstoffatomen eine Arylgruppe mit 4 bis 24 Kohlenstoffatomen oder eine Aralkylgruppe mit 5 bis 16 Kohlenstoffatomen bedeutet, $R^9$ dieselbe Bedeutung wie $R^8$ hat, aber auch für eine Dialkylaminogruppe mit 2 bis 6 Kohlenstoffatomen oder, falls $R^8$ eine besagte Alkylgruppe darstellt, auch für eine Arylaminogruppe mit 4 bis 8 Kohlenstoffatomen stehen kann, $R^{10}$ und $R^{11}$ unabhängig voneinander dieselbe Bedeutung wie $R^8$ haben, aber auch für ein Wasserstoffatom stehen können, r 1, 2 oder 3 ist, $Z^{r-}$ ein r-wertiges Anion einer Protonensäure, vorzugsweise einer anorganischen Säure, bedeutet und q bei p = Null für Null bzw. bei p = 1 für Null oder 1 steht.

In der Formel VI können $R^6$ eine homocyclische oder heterocyclische Arylen- oder Aralkylengruppe und $R^8$ und $R^9$ eine homocyclische oder heterocyclische Aryl- oder Aralkylgruppe bedeuten, und $R^9$ kann andererseits für eine homocyclische oder heterocyclische Arylaminogruppe stehen. Unter »heterocyclisches Aryl«, »heterocyclisches Arylen« oder »heterocyclisches Aralkylen« versteht man eine aromatische Gruppe, in der mindestens eine $-CH_2-$ oder $-CH=$ Gruppe eines Rings einer aromatischen Verbindung durch ein von Kohlenstoff verschiedenes Atom, üblicherweise Stickstoff, Sauerstoff oder Schwefel, ersetzt ist. Beispiele für heterocyclische Arylgruppen sind 2-Furylreste und 2-Pyridylreste und heterocyclische Arylengruppen sind beispielsweise Furan-2,4-diyl- und Pyridin-2,6-diylreste.

Vorzugsweise bedeutet $R^6$ eine homocyclische Gruppe mit 6 bis 25 Kohlenstoffatomen, z. B. eine Anthrylen-, Phenanthrylen- oder Fluorenylengruppe, doch steht es vorzugsweise für eine homocyclische Arylen- oder Aralkylengruppe mit 6 bis 11 Kohlenstoffatomen, insbesondere eine Phenylen- oder Naphthylengruppe oder eine Phenylenmethylengruppe der Formel

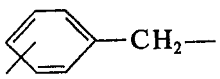

(VIII)

oder eine Xylylengruppe, welche im bzw. in den Ring(en) durch eine oder zwei Alkylgruppen mit je 1 bis 4 Kohlenstoffatomen, eine oder zwei Alkoxygruppen mit je 1 bis 4 Kohlenstoffatomen oder ein oder zwei Chlor-, Brom- oder Fluoratome substituiert sein können. $R^8$ und $R^9$ sind vorzugsweise je eine Alkylgruppe mit 1 bis 4 Kohlenstoffatomen oder eine gegebenenfalls im bzw. in den Ring(en) durch eine oder zwei Alkylgruppen mit je 1 bis 4 Kohlenstoffatomen, eine oder zwei Alkoxygruppen mit je 1 bis 4 Kohlenstoffatomen oder ein oder zwei Fluor-, Chlor- oder Bromatome substituierte Phenyl- oder Naphthylgruppe.

$R^{10}$ und $R^{11}$ stehen vorzugsweise beide für ein Wasserstoffatom.

$Z^{r-}$ kann beispielsweise $CH_3SO_4^-$, $C_6H_5SO_3^-$, p-$CH_3C_6H_4SO_3^-$, $CF_3SO_3^-$ oder $CF_3COO^-$ darstellen; vorzugsweise bedeutet es $Cl^-$, $Br^-$, $NO_3^-$, $HSO_4^-$, $HSO_3^-$, $ClO_4^-$, $H_2PO_4^-$, $SO_4^{--}$, $PO_4^{---}$ oder ein Anion der Formel,

$$MX_n^- \quad \text{(IX)}$$

worin M für ein Metall- oder Metalloidatom und X für ein Halogenatom, vorzugsweise Fluor oder Chlor, stehen und n 4, 5 oder 6 und um eines höher als die Wertigkeit von M ist, oder der Formel

$$SbF_5(OH)^- \quad \text{(X).}$$

M bedeutet vorzugsweise ein Bor- oder Wismut- und ganz besonders ein Antimon-, Arsen- oder Phosphoratom. Als Anion(en) $MX_n^-$ können also beispielsweise Hexachlorowismutat oder Tetrafluoroborat, aber besonders bevorzugt $PF_6^-$, $SbF_6^-$ oder $AsF_6^-$ vorliegen.

Spezielle Beispiele für geeignete Sulfoxoniumsalze sind:

Dimethylphenylsulfoxonium-hexafluorophosphat, Dimethylphenylsulfoxonium-perchlorat, Dimethylphenacylsulfoxonium-hexafluorophosphat und das entsprechende Hexafluoroantimonat, Dimethylphenacylsulfoxonium-chlorid, Diphenylphenacylsulfoxonium-hexafluorophosphat, 1,4-Bis-(1-oxo-2-(dimethylsulfoxonium)-äthyl)-benzol-dihexafluoroarsenat und das entsprechende Dihexafluoroantimonat, 1,4-Bis-(1-oxo-2-(dimethylsulfoxonium)-äthyl)-benzol-dichlorid, (Dimethylamino)-diphenylsulfoxonium-tetrafluoroborat, (Diäthylamino)-diphenylsulfoxonium-hexafluorophosphat, Dodecylmethylbenzylsulfoxonium-hexafluorophosphat, Triphenylsulfoxonium-hexafluorophosphat und Tris-(dimethylphenacylsulfoxonium)-phosphat.

Die erfindungsgemäßen Zusammensetzungen enthalten vorzugsweise 0,1 bis 7,5 und insbesondere 0,5 bis 5,0 Gewichtsteile (b) auf 100 Gewichtsteile (a).

Eine Untergruppe der Salze der Formel VI sind solche der Formeln

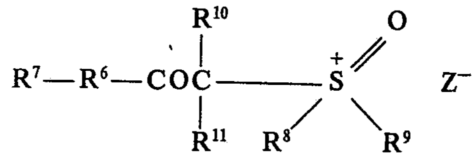

(XI)

oder

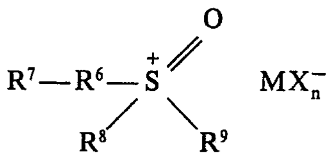

(XII)

oder

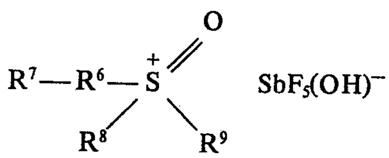

(XIII)

worin $R^6$ bis $R^{11}$, $MX_n^-$ und $Z^-$ die zuvor angegebenen Bedeutungen haben.

Die Sulfoxoniumsalze der Formel VI lassen sich nach mehreren Methoden herstellen.

1. Solche, in denen p Null ist, $R^6$ eine Arylengruppe, $R^7$ ein Wasserstoffatom und $R^9$ eine Alkyl-, Alkenyl-, Cycloalkyl-, Cycloalkylalkyl- oder eine Aralkylgruppe wie oben bedeuten und $R^8$ die zuvor angegebene Bedeutung hat, sind durch Umsetzung eines arylhaltigen Sulfoxyds der Formel

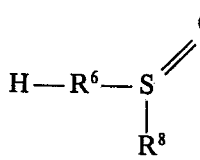

(XIV)

mit einem Jodid der Formel $R^9J$, worin $R^9$ eine Alkyl-, Alkenyl-, Cycloalkyl-, Cycloalkylalkyl- oder Aralkylgruppe bedeutet, erhältlich. Eine solche direkte S-Alkylierung der arylhaltigen Sulfoxyde hat sich als undurchführbar erwiesen, und es ist notwendig, über die Bildung des Merkuritrijodidsalzes vorzugehen, wie von M. Kobayashi u. a., Bull. Chem. Soc. Japan, 1072, 45, 3703-6, und K. Kamiyama u. a., ibid., 1973, 46, 2255-6 beschrieben. Das Merkuritrijodid läßt sich beispielsweise in das Hexafluorophosphat überführen, entweder direkt durch doppelte Umsetzung mit Silber-hexafluorophosphat oder indirekt durch doppelte Umsetzung mit Silber-perchlorat und anschließende doppelte Umsetzung des Sulfoxoniumperchlorats mit Kalium-hexafluorophosphat.

2. Die Bis-sulfoxoniumsalze, worin p und q je Null sind, $R^7$ eine Gruppe der Formel

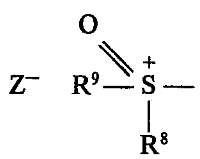

(XV)

$R^9$ eine Alkyl-, Alkenyl-, Cycloalkyl-, Cycloalkylalkyl- oder eine Aralkylgruppe und $R^6$ eine Arylengruppe bedeuten und $R^8$ die zuvor angegebene Bedeutung hat, kann man auf analoge Weise aus einem Bis-sulfoxyd der Formel

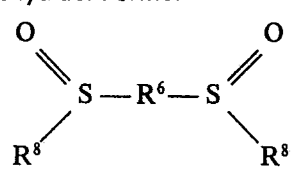

(XVI)

erhalten.

3. Zur Herstellung von Monosulfoxoniumsalzen der Formel VI, worin p 1 und q Null sind und $R^6$ eine Arylengruppe und $R^7$ ein Wasserstoffatom bedeuten, kann man ein Aroylchlorid $HR^6COCl$ wie Benzoylchlorid oder p-Toluoylchlorid mit einem Sulfoxonium-ylid der Formel

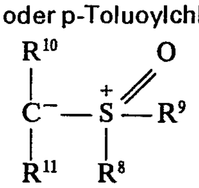

(XVII)

umsetzen und anschließend, falls mindestens eines von $R^{10}$ und $R^{11}$ ein Wasserstoffatom bedeutet, mit einer Protonensäure HZ neutralisieren (siehe U.S. Patentschrift Nr. 3 442 901). Dabei kann man auch ein Säureanhydrid $HR^6CO-O-COR^6H$ als Acylierungsmittel verwenden. So liefert die Umsetzung von 2 Mol Dimethylsulfoxonium-methylid (XVIII) mit Benzoylchlorid (XIX) Dimethylsulfoxonium-phenacylylid (XX), dessen Neutralisation mit Chlorwasserstoff Dimethylphenacylsulfoxonium-chlorid (XXII, Z=Cl) ergibt, während Neutralisation mit Hexafluorophosphorsäure oder Tetrafluoroborsäure zum entsprechenden Hexafluorophosphat (XXII, $Z=PF_6$) oder Tetrafluoroborat (XXII, $Z=BF_4$) führt. Das Hexafluorophosphat und ähnliche Salze wie das Hexafluoroarsenat (XXII, $Z=PF_6$ bzw. $AsF_6$) sind ferner auch durch doppelte Umsetzung mit dem Chlorid (XXII, Z=Cl) erhältlich.

Bedeutet eines von $R^{10}$ und $R^{11}$ ein Wasserstoffatom wie auch das Ylid, so bildet sich ein Sulfoxoniumsalz als Nebenprodukt; somit erhält man bei der Bildung des Ylids (XX) Trimethylsulfoxoniumchlorid (XXI) als Nebenprodukt. Wenn wie im vorliegenden Beispiel dieses Nebenprodukt keine Arylgruppe enthält, so ist es als Photopolymerisiermittel unwirksam. Im allgemeinen stört es jedoch nicht, kann aber gewünschtenfalls von dem erwünschten Aracylsulfoxoniumsalz dadurch getrennt werden, daß man z. B. letzteres in Aceton extrahiert.

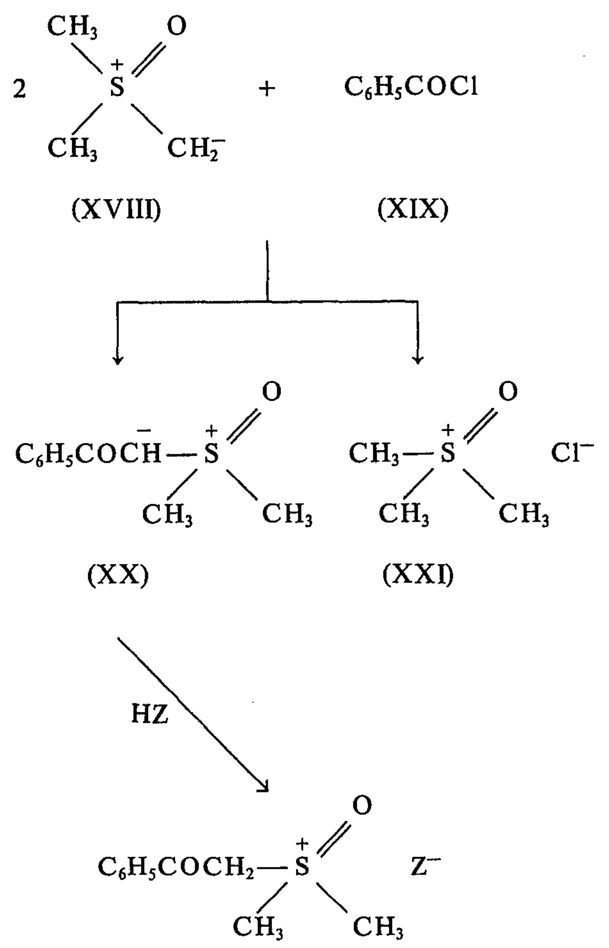

(XVIII) (XIX)

(XX) (XXI)

(XXII)

Die Umsetzung von 2 Mol Dimethylsulfoxonium-methylid (XVIII) mit Benzoesäureanhydrid liefert ein Gemisch aus Dimethylsulfoxonium-phenacylylid (XX) und Trimethylsulfoxonium-benzoat; das Ylid läßt sich von dem Benzoat abtrennen und auf ähnliche Weise durch Neutralisation mit Chlorwasserstoff in das Chlorid umwandeln.

4. Bei der Herstellung von Bis-sulfoxoniumsalzen der Formel VI, worin p 1 und q Null oder 1 sind und $R^6$ eine Arylengruppe und $R^7$ eine Gruppe der Formel VII bedeuten, lassen sich diese auf analoge Weise aus dem Sulfoxonium-ylid der Formel XVII und einem Aroylendichlorid der Formel $ClCOR^6COCl$ erhalten.

5. Andernfalls kann man zur Herstellung eines Monosulfoxoniumsalzes bzw. Bis-sulfoxoniumsalzes der Formel VI, worin p 1 und q Null oder 1 sind und $R^6$ eine Arylengruppe bedeutet, wobei $R^{10}$ und $R^{11}$ beide für ein Wasserstoffatom stehen, ein $\alpha$-Diazoacetophenon der Formel

$$H-R^6-COCHN_2 \qquad (XXIII)$$

bzw. eine Bis-($\alpha$-diazo)-verbindung der Formel

$$N_2CHCO-R^6-COCHN_2 \qquad (XXIV)$$

in Gegenwart von Kupferacetylacetonat, wie von M. Takebayashi u. a. (Chemistry Letters, 1973, 809-12) beschrieben mit 1 bzw. 2 Mol eines Sulfoxyds der Formel $R^8R^9SO$ umsetzen, wobei sich ein Ylid der Formel

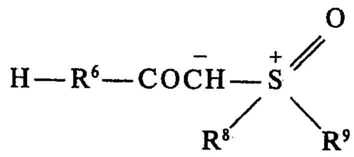

(XXV)

bzw. ein Bis-ylid der Formel

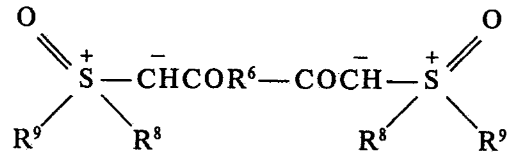

(XXVI)

bildet, welches mit einer Protonensäure HZ behandelt wird.

6. Zur Herstellung von Verbindungen der Formel VI, worin p und q Null sind und $R^6$ eine Arylengruppe und $R^9$ eine Dialkylaminogruppe bedeuten, behandelt man ein Arylsulfoxyd der Formel XIV nach der von S. Oae u. a., Int. J. Sulfur Chem. Part A 1972, 2, 49-61, beschriebenen Methode mit Stickstoffwasserstoffsäure, wobei sich das S-Arylsulfoximin der Formel

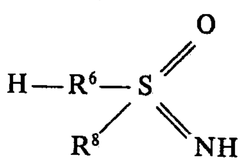

(XXVII)

bildet, welches nach der von C. R. Johnson u. a., J. Amer. Chem. Soc. 1973, 95, 7692-7700 beschriebenen Arbeitsweise durch Umsetzung mit einem Trialkyloxoniumsalz wie Triäthyloxonium-hexafluorophosphat oder Trimethyloxonium-tetrafluoroborat direkt in das Dialkylaminosulfoxoniumsalz überführt wird.

7. Zur Herstellung von Verbindungen der Formel VI, worin p Null ist, $R^6$ eine Arylengruppe, $R^8$ eine Alkylgruppe und $R^9$ eine Arylaminogruppe bedeuten, wird ein Arylsulfoxyd der Formel XIV mit dem entsprechenden Arensulfonylazid umgesetzt, d. h. die Reaktion des Arylsulfoxyds mit Toluol-p-sulfonylazid liefert das N-p-Tolyl-S-arylsulfoximin (S. Oae u. a., ibid.), welches dann wie oben mit einem Trialkyloxoniumsalz zum N-p-Tolyl-N-alkyl-sulfoxoniumsalz umgesetzt wird.

Solche Verbindungen, worin p und q beide Null sind, $R^6$ eine Aralkylengruppe und $R^7$ ein Wasserstoffatom bedeuten, $R^8$ die zuvor angegebene Bedeutung hat und $R^9$ eine Methylgruppe darstellt, lassen sich dadurch erhalten, daß man ein aralkylhaltiges Sulfoxyd der Formel XIV wie Dodecylbenzylsulfoxyd oder Hexadecylbenzylsulfoxyd mit Dimethylsulfat umsetzt, wie in U.S. Patentschrift Nr. 3 196 184 beschrieben, was das Methosulfat der Formel

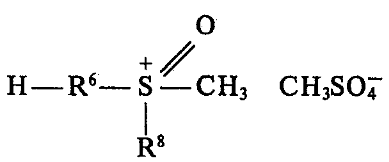

(XXVIII)

liefert.

Das Methosulfatanion läßt sich dann gewünschtenfalls nach herkömmlichen Anionenaustauschmethoden durch ein anderes Anion ersetzen.

9. Salze der Formel VI, worin p Null ist und $R^7$ ein Wasserstoffatom, $R^6$ eine Arylengruppe und $R^8$ und $R^9$ beide eine Arylgruppe bedeuten, sind durch Oxydation des entsprechenden Triarylsulfoniumsalzes mit z. B. m-Chlorperbenzoesäure erhältlich.

Wo eine bestimmte Protonensäure $H_tZ$ nicht zur Verfügung steht oder schwierig zu handhaben ist, kann man Salze wie Hexafluorophosphate und Hexafluoroantimonate durch doppelte Umsetzung mit den entsprechenden Chloriden oder anderen geeigneten Salzen herstellen. Beispielsweise kann man Diphenylphenacylsulfoxonium-hexafluorophosphat durch Ausfällen beim Zusatz einer wäßrigen Lösung von Kalium-hexafluorophosphat zu einer wäßrigen Lösung des Chlorids erhalten. Die Hexafluoroantimonate können durch Zugabe von festem Natrium- oder Kalium-hexafluoroantimonat zu einer wäßrigen Lösung des Sulfoxoniumchlorids hergestellt werden; löst man das Natrium- oder Kalium-hexafluoroantimonat zunächst in Wasser, so ist das isolierte Produkt dann wegen Hydrolyse das Hydro-

xopentafluoroantimonat ($MX^-_n = SbF_5(OH)^-$).

Die Komponente (a) kann beispielsweise ein Oxetan, ein Thi-iran oder ein Tetrahydrofuran sein. Vorzugsweise ist dies ein 1,2-Epoxid, ein Vinylmonomer oder -präpolymer, ein Aminoplast oder ein Phenoplast.

Im Fall eines 1,2-Epoxids muß $Z^-$ in der Formel VI (und falls vorhanden in der Formel VII) für eine Gruppe $MX^-_n$ wie oben oder $SbF_5(OH)$ stehen. Als Komponente (a) kann beispielsweise ein Mono-1,2-epoxid wie Epichlorhydrin, Propylenoxyd oder ein Glycidyläther eines einwertigen Alkohols oder Phenols, wie n-Butylglycidyläther oder Phenylglycidyläther, vorliegen; dies kann auch z. B. ein Glycidylester wie Glycidylacrylat oder Glycidylmethacrylat sein. Vorzugsweise ist es ein Epoxidharz, insbesondere ein solches, das mindestens eine direkt an ein Sauerstoffatom gebundene Gruppe der Formel

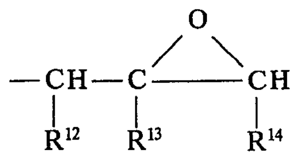

(XXIX)

enthält, worin entweder $R^{12}$ und $R^{14}$ je ein Wasserstoffatom darstellen, in welchem Fall $R^{13}$ ein Wasserstoffatom oder eine Methylgruppe bedeutet, oder $R^{12}$ und $R^{14}$ zusammen $-CH_2CH_2-$ darstellen, in welchem Fall $R^{13}$ ein Wasserstoffatom bedeutet.

Als Beispiele für solche Harze seien Polyglycidyl- und Poly-(β-methylglycidyl)-ester genannt, die man durch Umsetzung einer zwei oder mehr Carbonsäuregruppen pro Molekül enthaltenden Verbindung mit Epichlorhydrin, Glycerin-dichlorhydrin oder β-Methylepichlorhydrin in Gegenwart von Alkali erhalten kann. Solche Polyglycidylester können sich von aliphatischen Polycarbonsäuren, z. B. Bernsteinsäure, Glutarsäure, Adipinsäure, Pimelinsäure, Korksäure, Azelainsäure, Sebacinsäure oder dimerisierter oder trimerisierter Linolsäure, von cycloaliphatischen Polycarbonsäuren wie Tetrahydrophthalsäure, 4-Methyltetrahydrophthalsäure, Hexahydrophthalsäure und 4-Methylhexahydrophthalsäure und von aromatischen Polycarbonsäuren wie Phthalsäure, Isophthalsäure und Terephthalsäure ableiten. Weitere geeignete Polyglycidylester sind durch Polymerisation der Glycidylester von Vinylsäuren, insbesondere Glycidylacrylat und Glycidylmethacrylat, erhältlich.

Weitere Beispiele sind Polyglycidyl- und Poly-(β-methylglycidyl)-äther, die durch Umsetzung einer mindestens zwei freie alkoholische und/oder phenolische Hydroxylgruppen pro Molekül enthaltenden Verbindung mit dem entsprechenden Epichlorhydrin unter alkalischen Bedingungen, oder auch in Gegenwart eines sauren Katalysators mit nachfolgender Alkalibehandlung erhältlich sind.

Diese Äther lassen sich mit Poly-(epichlorhydrin) aus acyclischen Alkoholen wie Äthylenglykol, Diäthylenglykol und höheren Poly-(oxyäthylen)-glykolen, Propan-1,2-diol und Poly-(oxypropylen)-glykolen, Propan-1,3-diol, Poly-(oxytetramethylen)-glykolen, Pentan-1,5-diol, Hexan-2,4,6-triol, Glycerin, 1,1,1-Trimethylolpropan, Penta-erythrit und Sorbit, aus cycloaliphatischen Alkoholen wie Resorcit, Chinit, Bis-(4-hydroxy-cyclohexyl)-methan, 2,2-Bis-(4-hydroxycyclohexyl)-propan und 1,1-Bis-(hydroxymethyl)-cyclohexen-3, sowie aus Alkoholen mit aromatischen Kernen, wie N,N-Bis-(2-hydroxyäthyl)-anilin und p,p'-Bis-(2-hydroxyäthylamino)-diphenylmethan, herstellen. Man kann sie ferner aus einkernigen Phenolen wie Bis-(4-hydroxyphenyl)-methan (sonst als Bisphenol F bekannt), 4,4'-Dihydroxydiphenyl, Bis-(4-hydroxyphenyl)-sulfon, 1,1,2,2-Tetrakis-(4-hydroxyphenyl)-äthan, 2,2-Bis-(4-hydroxyphenyl)-propan (sonst als Bisphenol A bekannt) und 2,2-Bis-(3,5-dibrom-4-hydroxyphenyl)-propan, sowie aus Aldehyden wie Formaldehyd, Acetaldehyd, Chloral und Furfurol mit Phenol selbst und durch Chloratome oder Alkylgruppen mit jeweils bis zu neun Kohlenstoffatomen ringsubstituiertes Phenol, wie 4-Chlorphenol, 2-Methylphenol und 4-tert.-Butylphenol, gebildeten Novolaken herstellen.

Poly-(N-glycidyl)-verbindungen lassen sich ebenfalls verwenden, beispielsweise N-Glycidylderivate von Aminen wie Anilin, n-Butylamin, Bis-(4-aminophenyl)-methan und Bis-(4-methylaminophenyl)-methan, Triglycidylisocyanurat sowie N,N'-Diglycidylderivate von cyclischen Alkylenharnstoffen wie Äthylenharnstoff und 1,3-Propylenharnstoff, und Hydantoinen wie 5,5'-Dimethyldantoin. Im allgemeinen sind diese jedoch nicht bevorzugt.

Ebenfalls kann man Poly-(S-glycidyl)-verbindungen einsetzen, z. B. Di-(S-glycidyl)-derivate von Dithiolen wie Äthan-1,2-dithiol und Bis-(4-mercaptomethylphenyl)-äther, doch werden auch diese nicht bevorzugt.

Beispiele für Epoxidharze mit Gruppen der Formel XXIX, worin $R^{12}$ und $R^{14}$ zusammen eine $-CH_2CH_2$-Gruppe bedeuten, sind Bis-(2,3-epoxycyclopentyl)-äther, 2,3-Epoxycyclopentyl-glycidyläther und 1,2-Bis-(2,3-epoxycyclopentyloxy)-äthan.

In Betracht kommen auch Epoxidharze, in denen die 1,2-Epoxidgruppen an Heteroatome verschiedener Art gebunden sind, z. B. der Glycidyläther/Glycidylester der Salicylsäure.

Ebenfalls verwendbar sind Epoxidharze, in denen einige oder sämtliche Epoxidgruppen mittelständig sind, wie Vinylcyclohexendioxyd, Limonendioxyd, Dicyclopentadiendioxyd, 4-Oxatetracyclo-$[6.2.1.0^{2,7}.0^{3,5}]$undecyl-9-glycidyläther, 1,2-Bis-(4-oxatetracyclo-$[6.2.1.0^{2,7}.0^{3,5}]$undecyl-9-oxy)-äthan, der 3,4-Epoxycyclohexylmethylester der 3',4'-Epoxycyclohexancarbonsäure sowie dessen 6,6'-Dimethylderivat, der Bis-(3,4-epoxycyclohexancarbonsäureester) des Äthylenglykols, 3-(3,4-epoxycyclohexyl)-8,9-epoxy-2,4-dioxaspiro[5,5]undecan sowie epoxidierte Butadiene oder Copolymere des Butadiens mit Äthylenverbindungen wie Styrol und Vinylacetat.

Gewünschtenfalls kann man Epoxidharzgemische verwenden.

Besonders bevorzugte, bei dem erfindungsgemäßen Verfahren verwendete, gegebenenfalls vorverlängerte Epoxidharze sind die Diglycidyläther von zweiwertigen Phenolen, wie 2,2-Bis-(4-hydroxyphenyl)-propan und Bis-(4-hydroxyphenyl)-methan, und von zweiwertigen aliphatischen Alkoholen wie Butan-1,4-diol.

Gewünschtenfalls kann man das Epoxidharz einer Mischhärtung mit einem mehrwertigen Alkohol, d. h. einer Verbindung mit mindestens zwei alkoholischen, vorzugsweise primären Hydroxylgruppen im Molekül, unterwerfen. Vorzugsweise liegt der mehrwertige Alkohol in genügender Menge vor, um 0,5 bis 1,5, insbesondere 0,75 bis 1,25, alkoholische Hydroxylgruppen pro 1,2-Epoxidgruppe des Epoxidharzes zu liefern. Der mehrwertige Alkohol enthält vorzugsweise außer den alkoholischen Hydroxylgruppen nur Kohlenstoff-, Wasserstoff- und gegebenenfalls als Äthersauerstoff oder Acetal oder Carbonylgruppen vorhandene Sauerstoff- sowie Halogenatome. Ferner besitzt der mehrwertige Alkohol vorzugsweise ein Molekulargewicht von mindestens 100 und insbesondere höher als 1000. Geeignete mehrwertige Alkohole sind beispielsweise Poly-(oxyäthylen)-glykole, Poly-(oxypropylen)-glykole, Poly-(oxytetramethylen)-glykole, Polyepichlorhydrine, Poly-(oxyäthylen)-, Poly-(oxypropylen)-, bzw. Poly-(oxytetramethylen)-triole, die durch Polymerisation von Äthylenoxyd, Propylenoxyd bzw. Tetrahydrofuran in Gegenwart von Glycerin oder 1,1,1-Trimethylolpropan erhältlich sind, Polycaprolactone mit Hydroxylendgruppen, Copolymere des Styrols mit Allylalkohol, Polyvinylalkohole, Hydroxypropylcellulose, hydroxylhaltige Polyvinylacetale und Teilester der Cellulose, z. B. ein Celluloseacetatbutyrat.

Vinylmonomere und -präpolymere, die dabei polymerisiert werden können, sind unter anderem Styrol, $\alpha$-Methylstyrol, Allylbenzol, Divinylbenzol, Vinylcyclohexan, 4-Vinylcyclohexen-1, N-Vinylpyrrolidinon-2, N-Vinylcarbazol, Acrolein, Isopren, Butadien, Piperylen, Vinylacetat und Vinyläther wie Isobutylvinyläther, Methylvinyläther, Trimethylolpropan-trivinyläther, Glycerintrivinyläther, die Vinyläther von Äthylenglykol und Poly-(oxyäthylenglykolen) und cyclische Vinyläther mit mindestens zwei cyclischen Vinyläthergruppen, die jeweils einen Teil eines 3,4-Dihydro-2H-pyrankerns bilden, wie der 3,4-Dihydro-2H-pyranyl-(2)-methylester der 3,4-Dihydro-2H-pyran-2-carbonsäure und dessen Präpolymere. Die bevorzugten Vinylverbindungen sind Vinyläther von aliphatischen einwertigen Alkoholen mit 1 bis 4 Kohlenstoffatomen sowie der 3,4-Dihydro-2H-pyranyl-(2)-methylester der 3,4-Dihydro-2H-pyran-2-carbonsäure und dessen Präpolymere.

Die als Komponente (a) bevorzugten Aminoplaste enthalten pro Molekül mindestens zwei direkt an ein Amid- oder Thioamidstickstoffatom bzw. -atome gebundene Gruppen der Formel $-CH_2OR^{15}$, worin $R^{15}$ ein Wasserstoffatom, eine Alkylgruppe mit 1 bis 4 Kohlenstoffatomen oder eine Acetylgruppe bedeutet. Beispiele für solche Aminoplaste sind die N-Hydroxymethyl-, N-Methoxymethyl-, N-Butoxymethyl- und N-Acetoxymethylderivate der folgenden Amide und amidartigen Substanzen:

I. Harnstoff, Thioharnstoff und cyclische Harnstoffe der Formel

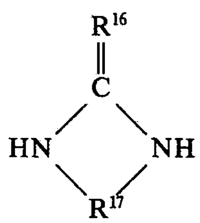

(XXX)

worin $R^{16}$ Sauerstoff oder Schwefel und $R^{17}$ entweder eine Gruppe der Formel

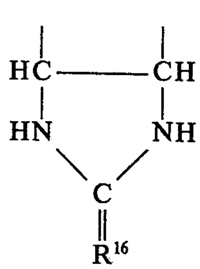

(XXXI)

oder eine gegebenenfalls durch Methyl-, Methoxy- oder Hydroxylgruppen substituierte und gegebenenfalls durch $-CO-$, $-O-$ oder $-N(R^{18})-$, wobei $R^{18}$ für eine Alkyl- oder Hydroxyalkylgruppe mit bis zu 4 Kohlenstoffatomen steht, unterbrochene zweiwertige Gruppe mit 2 bis 4 Kohlenstoffatomen darstellen.

Solche cyclischen Harnstoffe sind beispielsweise Äthylenharnstoff (Imidazolidinon-2), Dihydroxyäthylenharnstoff (4,5-Dihydroxyimidazolidinon-2), Hydantoin, Uron (Tetrahydro-oxadiazinon-4),

1,2-Propylenharnstoff (4-Methylimidazolidinon-2), 1,3-Propylenharnstoff (Hexahydro-2H-pyrimidon-2), Hydroxypropylenharnstoff (5-Hydroxyhexadydro-2H-pyrimidon-2), Dimethylpropylenharnstoff (5,5-Dimethylhexahydro-2H-pyrimidon-2), Dimethylhydroxypropylenharnstoff bzw. Dimethylmethoxypropylenharnstoff (4-Hydroxy- bzw. 4-Methoxy-5,5-dimethylhexahydro-2H-pyrimidon-2), 5-Äthyltriazinon-2 und 5-(2-Hydroxyäthyl)-triazinon-2. II. Carbamate und Dicarbamate aliphatischer einwertiger und zweiwertiger Alkohole mit bis zu vier Kohlenstoffatomen, z. B. Methyl-, Äthyl-, Isopropyl-, 2-Hydroxyäthyl-, 2-Methoxyäthyl-, 2-Hydroxy-n-propyl- und 3-Hydroxy-n-propylcarbamate sowie Äthylen- und 1,4-Butylendicarbamate. III. Melamin und weitere Polyamino-1,3-triazine wie Acetoguanamin, Benzoguanamin und Adipoguanamin.

Gewünschtenfalls kann man Aminoplaste einsetzen, die sowohl N-Hydroxymethyl- als auch N-Alkoxymethyl- oder N-Hydroxymethyl- und N-Acetoxymethylgruppen enthalten (beispielsweise ein Hexamethylolmelamin, in dem 1 bis 3 Hydroxylgruppen mit Methylgruppen veräthert sind).

Die bevorzugten Aminoplaste sind Kondensationsprodukte des Harnstoffs, Urons, Hydantoins oder Melamins mit Formaldehyd sowie teilweise oder völlig verätherte Produkte solcher Kondensationsprodukte mit einem aliphatischen einwertigen Alkohol mit 1 bis 4 Kohlenstoffatomen. Spezielle Beispiele für geeignete Aminoplaste sind Hexamethoxymethylmelamin und ein Kondensationsprodukt aus Harnstoff mit 1,8 Mol Formaldehyd.

Als Phenoplaste werden aus einem Phenol und einem Aldehyd hergestellte Resole bevorzugt. Als Phenole eignen sich unter anderem Phenol selbst, Resorcin, 2,2-Bis-(p-hydroxyphenyl)-propan, p-Chlorphenol, ein durch ein oder zwei Alkylgruppen mit jeweils 1 bis 9 Kohlenstoffatomen substituiertes Phenol, wie o-, m- und p-Kresol, die Xylenole, p-tertiär-Butylphenol, p-Nonylphenol und phenylsubstituierte Phenole, insbesondere p-Phenylphenol. Der mit dem Phenol kondensierte Aldehyd ist vorzugsweise Formaldehyd, doch kommen auch andere Aldehyde wie Acetaldehyd und Furfurol in Frage. Gewünschtenfalls kann man ein Gemisch aus solchen härtbaren Phenol/Aldehydharzen verwenden.

Die bevorzugten Resole sind Kondensationsprodukte des Phenols, p-Chlorphenols, Resorcins oder O-, m- oder p-Kresols mit Formaldehyd.

Vorzugsweise enthalten die erfindungsgemäßen Zusammensetzungen auch einen Sensibilisator. Es wurde gefunden, daß die Einarbeitung geeigneter Sensibilisatoren die Härtungsgeschwindigkeit noch weiter steigert, was die Anwendung noch kürzerer Belichtungszeiten und/oder weniger starker Bestrahlungsquellen ermöglicht. Außerdem wird die Empfindlichkeit für sichtbares Licht erhöht. Von Farbstoffen verschiedene Sensibilisatoren haben sich als wirksamer erwiesen, insbesondere aromatische polycyclische Verbindungen mit mindestens drei kondensierten Benzolringen und mit einer Ionisationsenergie unter etwa 7,5 eV. Geeignete Sensibilisatoren dieser Art sind in der U.S. Patentschrift Nr. 4 069 054 beschrieben und schließen Anthracen, Rubran, Perylen, Phenanthren, Fluoranthen und Pyren ein.

Vorzugsweise arbeitet man 0,1 bis 2% und insbesondere 0,25 bis 0,75 Gew.-% des Sensibilisators, berechnet auf das Gewicht von (a), ein.

Beim Photopolymerisationsvorgang verwendet man vorzugsweise aktinische Strahlung einer Wellenlänge von 200 bis 600 nm. Als aktinische Strahlungsquellen eignen sich unter anderem Kohlelichtbögen, Quecksilberdampflichtbögen, Leuchtröhren mit ultraviolettes Licht ausstrahlenden Leuchtstoffen, Argon- und Xenonglimmlampen, Wolframlampen und photographische Flutlampen. Darunter sind Quecksilberdampflichtbögen, insbesondere Höhensonnen, fluoreszierende Höhensonnen und Metallhalogenidlampen am besten geeignet. Die zur Belichtung erforderliche Zeit wird von verschiedenen Faktoren abhängen, unter anderem beispielsweise dem jeweils verwendeten polymerisierbaren Substrat, der Art der Lichtquelle und deren Abstand vom bestrahlten Material. Der mit Photopolymerisationsmethoden vertraute Fachmann kann die geeigneten Zeiten leicht bestimmen. Wenn es wie in dem unten beschriebenen Verfahren erforderlich ist, daß das so photopolymerisierte Produkt beim Erhitzen mit einem eingemischten Heißhärter noch härtbar ist, dann muß die Bestrahlung natürlich bei einer Temperatur unterhalb derjenigen, bei der weitgehende Heißhärtung des photopolymerisierten Produkts durch den Heißhärter eintreten würde, erfolgen.

Die erfindungsgemäßen Zusammensetzungen sind als Oberflächenbeschichtungen verwendbar. Man kann sie, vorzugsweise als Flüssigkeit, auf ein Substrat wie Stahl, Aluminium, Kupfer, Cadmium, Zink, Papier oder Holz aufbringen und bestrahlen. Polymerisiert man einen Teil der Beschichtung, wie bei Bestrahlung durch eine Maske hindurch, so kann man die unbelichteten Stellen mit einem Lösungsmittel waschen, um unpolymerisierte Anteile zu entfernen, während die photopolymerisierten, unlöslichen Anteile an Ort und Stelle verbleiben. Die erfindungsgemäßen Zusammensetzungen sind somit bei der Herstellung von Druckplatten und gedruckten Schaltungen verwendbar. Methoden zur Herstellung von Druckplatten und gedruckten Schaltungen aus photopolymerisierbaren Zusammensetzungen sind wohlbekannt (siehe z. B. britische Patentschrift Nr. 1 495 746).

Die Zusammensetzungen lassen sich auch als Klebstoffe verwenden. Eine Schicht der Zusammensetzung kann zwischen zwei Oberflächen von Gegenständen, von denen mindestens einer für aktinische Strahlung durchlässig ist, z. B. Glas, eingebracht werden, und der Aufbau wird dann bestrahlt und gewünschtenfalls erhitzt, um die Polymerisation zu vervollständigen.

Die Zusammensetzungen sind ferner bei der Herstellung von faserverstärkten Verbundstoffen,

einschließlich Plattenpreßmassen, verwendbar.

Dabei kann man sie in flüssiger Form direkt auf Verstärkungsfasern (einschließlich Spinnfäden, Endlosfäden und Whiskers) auftragen, die in Form von Gewebe- oder Faservlies, kettenstarken Schnitten oder Stapelseide vorliegen, insbesondere von Fasern aus Glas, Bor, Edelstahl, Wolfram, Aluminiumoxyd, Siliciumcarbid, Asbest, Kaliumtitanatwhiskers, einem aromatischen Polyamid wie Poly-(m-phenylenisophthylamid), Poly-(p-phenylenterephthalamid) oder Poly-(p-benzamid), Polyäthylen, Polypropylen oder Kohlenstoff.

Der faserverstärkte Verbundstoff kann nach einem diskontinuierlichen Verfahren hergestellt werden, indem man das faserförmige Verstärkungsmaterial auf eine Folie aus photopolymerisierter Zusammensetzung, die zweckmäßigerweise etwas unter Spannung steht, auflegt und wenn erwünscht eine zweite solche Folie darüberlegt und dann den Aufbau unter Erhitzen verpreßt. Auch ist kontinuierliche Herstellung dadurch möglich, daß man das faserförmige Verstärkungsmaterial mit der Folie aus photopolymerisierter Zusammensetzung in Berührung bringt und dann gewünschtenfalls eine zweite solche Folie auf die Rückseite des faserförmigen Verstärkungsmaterials legt und Hitze und Druck zur Einwirkung bringt. Zweckmäßiger bringt man zwei solche, vorzugsweise auf der Rückseite durch Bänder oder abziehbare Blätter abgestützte Folien gleichzeitig auf das faserförmige Verstärkungsmaterial so auf, daß die beiden freiliegenden Seiten in Berührung kommen. Werden zwei solche Folien aufgebracht, so können diese gleich oder verschieden sein.

Vielschichtige Verbundstoffe lassen sich dadurch herstellen, daß man abwechselnde Folien und Schichten aus einem oder mehreren faserförmigen Verstärkungsmaterialien unter Druck erhitzt. Bei Verwendung kettenstarker Fasern als Verstärkungsmaterial können deren aufeinanderfolgende Schichten so orientiert sein, daß sich gekreuzte Lagen ergeben.

Gegebenenfalls kann man mit dem faserförmigen Verstärkungsmaterial zusätzliche Verstärkungstypen wie eine Metallfolie (z. B. aus Aluminium, Stahl oder Titan) oder eine Kunststoffolie (aus einem aromatischen oder aliphatischen Polyamid, Polyimid, Polysulfon oder Polycarbonat) oder Kautschukfolie (z. B. aus Neopren oder Acrylnitrilkautschuk) verwenden.

Bei der Herstellung von Plattenpreßmassen wird eine erfindungsgemäße Zusammensetzung mit dem Stapelseideverstärkungsmaterial und gegebenenfalls weiteren Komponenten schichtweise einer Bestrahlung durch Trägerfolien hindurch ausgesetzt.

So viel polymerisierbare Zusammensetzung wird vorzugsweise eingesetzt, daß der Verbundstoff insgesamt 20 bis 80 Gew.-% dieser Zusammensetzung und dementsprechend 80 bis 20 Gew.-% Verstärkung enthält. Besonders bevorzugt verwendet man 30 bis 50 Gew.-% der Zusammensetzung.

Die erfindungsgemäßen Zusammensetzungen sind zur Herstellung von Kitten und Spachtelmassen verwendbar. Sie lassen sich als Tauchbeschichtungen anwenden, wobei ein zu beschichtender Artikel in die flüssige Zusammensetzung getaucht und wieder entnommen und die anhaftende Beschichtung zur Photopolymerisation und damit Verfestigung bestrahlt und gewünschtenfalls anschließend erhitzt wird.

Es wurde gefunden, daß es möglich ist, unter Verwendung der erfindungsgemäßen Zusammensetzungen Epoxidharze und Phenoplyste in zwei Stufen zu härten; zunächst wird das Harz durch Belichtung mit aktinischer Strahlung in Gegenwart eines Sulfoxoniumsalzes und eines latenten, hitzeaktivierbaren Vernetzungsmittels für das Epoxidharz oder Phenoplast in die teilweise gehärtete B-Stufe umgewandelt, und in einer zweiten Stufe wird die teilweise gehärtete Zusammensetzung so erhitzt, daß die Härtung mittels des hitzeaktivierbaren Vernetzungsmittels zu Ende geht. So kann man eine flüssige oder halbflüssige Zusammensetzung herstellen, die dann geformt oder zur Imprägnierung eines Substrats verwendet werden kann, während sie zur Verfestigung bestrahlt wird; der verfestigte Körper wird dann zur gewünschten Zeit erhitzt, um die Härtung des Harzes zu vervollständigen.

Gemäß einer weiteren Ausführungsform dieser Erfindung wird daher ein Epoxidharz oder ein Phenoplast in Gegenwart einer zur Polymerisation des Epoxidharzes oder Phenoplastes wirksamen Menge eines Sulfoxoniumsalzes der Formel VI und einer härtenden Menge eines latenten Heißhärters für das Epoxidharz oder Phenoplast unter Bildung des B-Stufenprodukts bestrahlt, und die Härtung der Zusammensetzung wird zur gewünschten Zeit durch Erhitzen vervollständigt.

Eine weitere Ausführungsform umfaßt eine Zusammensetzung, die ein Epoxidharz oder Phenoplast, eine zur Polymerisation dieses Epoxidharzes oder Phenoplastes bei Belichtung der Zusammensetzung mit aktinischer Strahlung wirksame Menge eines Sulfoxoniumsalzes der Formel VI und eine härtende Menge eines latenten Heißhärters für das Epoxidharz oder Phenoplast enthält.

Als hitzeaktivierbare Vernetzungsmittel für die Epoxidharzzusammensetzungen eignen sich unter anderem Polycarbonsäureanhydride, Komplexe von Aminen, insbesondere primären oder tertiären aliphatischen Aminen wie Äthylamin, Trimethylamin und n-Octyldimethylamin mit Bortrifluorid oder Bortrichlorid, und latente Bordifluoridchelate. Aromatische Polyamine und Imidazole sind im allgemeinen nicht bevorzugt, da sie ziemlich schlechte Resultate geben, möglicherweise wegen einer Reaktion zwischen dem freigesetzten sauren Katalysator und dem Amin. Dicyandiamid kann mit Erfolg verwendet werden, solange es als relativ grobe Teilchen vorliegt.

Geeignete hitzeaktivierbare Vernetzungsmittel für Resole sind unter anderem Hexamethylentetramin und Paraform.

Die für die Heißhärtung erforderliche Temperatur und Erhitzungsdauer sowie die Anteile an hitzeaktivierbarem Härter werden leicht durch Reihenversuche ermittelt und lassen sich ohne weiteres aus dem wohlbekannten Fachwissen über die Heißhärtung von Epoxidharzen und Phenol/Aldehydresolen ableiten.

Auf Grund dessen, daß die Zusammensetzungen Gruppen aufweisen, über die sie nach der Photopolymerisation heißgehärtet werden können, sind sie besonders bei der Herstellung von mehrlagigen gedruckten Schaltungen nützlich.

Herkömmlicherweise wird eine mehrlagige gedruckte Schaltung aus mehreren zweiseitigen Kupferleiterplatten hergestellt, die übereinander gestapelt und gegenseitig durch Isolierbögen, üblicherweise aus mit einem Epoxidharz oder Phenol/Formaldehydharz in der B-Stufe imprägnierter Glasfaser, getrennt werden. Wird kein Heißhärter in die photopolymerisierbare Harzschicht in der Leiterplatte eingemischt, so kann man sie in die mit den Platten alternierenden Isolierschichten einbringen, welche zweckmäßig aus einem Epoxidharz- oder Phenol/Formaldehydharzprepreg bestehen; vorausgesetzt der Prepreg ist nicht zu dick, wandert genügend darin enthaltener Heißhärter aus, um die Vernetzung des photopolymerisierten Epoxidharzes oder Phenol/Formaldehydharzes auszulösen. Zur gegenseitigen Verklebung der Schichten wird der Stapel erhitzt und verpresst. Herkömmliche photopolymerisierbare Materialien bilden jedoch weder mit Kupfer noch mit harzimprägnierten Glasfaserfolien einen starken Verbund. Wird ein Stapel verklebt, während das Photopolymer noch das Kupfer überdeckt, so ist er deshalb an sich schwach und kann im Gebrauch auseinanderblättern. In der normalen Praxis entfernt man deshalb das restliche Photopolymer nach der Ätzstufe entweder mittels starker Lösungsmittel oder durch eine mechanische Methode, z. B. mit Bürsten. Ein solches Abstreifverfahren kann das Kupfer der gedruckten Schaltung oder die Oberfläche des Verbunds, auf dem die Schaltung liegt, beschädigen, und es besteht daher ein Bedarf für eine Methode, bei der es nicht mehr nötig wäre, das photopolymerisierte Material vor dem gegenseitigen Verkleben der Platten zu entfernen. Die Gegenwart verbleibender Vernetzungsgruppen in den erfindungsgemäßen Zusammensetzungen hat zur Folge, daß bei der Verklebung der Platten eine Vernetzung eintreten kann, was zu guter Haftung am Kupfer und am harzimprägnierten Glasfasersubstrat führt, so daß der eben erwähnte Schritt entfällt.

Eine weitere Anwendung unter Heißhärtung nach der Photopolymerisation der erfindungsgemäßen Zusammensetzungen betrifft das Filamentwickeln. Dabei wird ein endloses Kabel der faserförmigen Verstärkung mit einer einen latenten Heißhärter enthaltenden Zusammensetzung imprägniert und dann unter gleichzeitiger Belichtung der Wicklung mit aktinischer Strahlung um einen Dorn oder Spulkörper gewickelt. Derartige Filamentwicklungen besitzen noch einen gewissen Grad Biegsamkeit, was gestattet, den Dorn oder Spulkörper leichter zu entfernen, als es bei einer in einem Schritt gebildeten starren Wicklung möglich wäre. Erforderlichenfalls kann man die Wicklung zur Vernetzung der Zusammensetzung erhitzen.

Bei einer weiteren solchen Anwendung wird eine Schicht der Zusammensetzung in flüssiger Form bis zur Verfestigung bestrahlt, wobei eine Klebfolie entsteht, die dann zwischen und in Berührung mit zwei zu verklebenden Oberflächen eingebracht wird, und der Aufbau wird erhitzt um die Vernetzung der Zusammensetzung zu vervollständigen. Auf einer Seite kann die Folie mit einem abziehbaren Unterlegblatt, z. B. aus einem Polyolefin oder Polyester oder einem cellulosehaltigen Papier mit einer Silikonbeschichtung als Trennmittel, versehen sein. Häufig läßt sich der Aufbau leichter handhaben, wenn die Folie eine klebrige Oberfläche aufweist. Dies läßt sich dadurch erzielen, daß man die Folie mit einer Substanz beschichtet, die bei Raumtemperatur klebrig ist, aber unter den zur Vervollständigung der Vernetzung der Zusammensetzung angewandten Hitzebedingungen zu einem harten, unlöslichen, unschmelzbaren Harz vernetzt. Jedoch liegt ein ausreichender Klebrigkeitsgrad häufig ohne zusätzliche Behandlung vor, insbesondere wenn die Polymerisation der Zusammensetzung nicht zu weit fortgeschritten ist. Geeignete Klebsubstrate schließen Metalle wie Eisen, Zink, Cadmium, Kupfer, Nickel und Aluminium, Keramik, Glas und Kautschuktypen ein.

Die nachfolgenden Beispiele erläutern die Erfindung. Teile sind Gewichtsteile, falls nicht anders angegeben. Die Biegefestigkeiten stellen den Durchschnitt aus drei Ergebnissen dar und wurden nach British Standard Nr. 2782, Methode 304B, bestimmt.

Die in diesen Beispielen eingesetzten Sulfoxoniumsalze wurden wie folgt hergestellt.

### Dimethylphenylsulfoxonium-hexafluorophosphat

Dies wird durch S-Methylierung von Methylphenylsulfoxyd in Gegenwart von Mercurijodid als Katalysator (M. Kobayashi u. a., Bull. Chem. Soc. Japan, 1972, 45, 3703; K. Kamiyama u. a., ibid., 1973, 46, 2255) und Umwandlung des Dimethylphenylsulfoxonium-mercuritrijodids in das Hexafluorophosphat, entweder direkt oder über das nach K. Ryoke u. a., ibid., 1976, 49, 1455, bereitete Perchlorat hergestellt.

Dabei erhitzt man ein Gemisch aus Jodmethan (200 Teile), Methylphenylsulfoxyd (20 Teile), Mercurijodid (21,7 Teile) 60 Stunden unter Stickstoff zum Rückfluß. Überflüssiges Jodmethan wird im Vakuum abdestilliert und unverändertes Methylphenylsulfoxyd durch Extraktion in Diäthyläther entfernt. Umkristallisieren des schwach gelben zurückbleibenden Pulvers aus Methanol liefert 12 Teile Dimethylphenylsulfoxonium-mercuritrijodid, Schmelzpunkt 137°—9°C, NMR-Spektrum (Aceton-

$d_6$)4,40 (S-6H) und 8,22 (m-5H).

Mercuritrijodid (11 Teile) löst man in 100 Teilen Aceton und tropft eine Lösung von 5 Teilen Silberhexafluorophosphat in Aceton dazu. Nach 15 Minuten Rühren werden das ausgefällte Mercurijodid und Silberjodid abfiltriert und das Filtrat eingedampft, wobei das gesuchte Hexafluorophosphat (VI, $R^7 = H$, $R^6 = C_6H_4$, p = Null, $R^8 = R^9 = CH_3$, r = 1, $Z^{r-} = PF_6^-$)als schwach gelbes Pulver zurückbleibt. Nach Umkristallisieren aus Methanol besteht es aus farblosen Nadeln, Schmelzpunkt 176° —80° C, NMR-Spektrum (Aceton-$d_6$) 4,35 (S-6H) und 8,18(m-5H).

Das gesuchte Hexafluorophosphat entsteht auch durch Umwandlung des Mercuritrijodids in Dimethylphenylsulfoxonium-perchlorat durch Behandlung mit einer Lösung von Silberperchlorat in Aceton (wie oben für die Umsetzung mit Silberhexafluorophosphat beschrieben) und nachfolgende Behandlung einer wäßrigen Lösung des Perchlorats mit Kaliumhexafluorophosphat.

Dimethylphenacylsulfoxonium-chlorid (Gemisch)

In einer Stickstoffatmosphäre tropft man Benzoylchlorid, (11,4 Teile) im Verlauf von 10 Minuten zu 300 Teilen einer 0,4-m-Lösung von Dimethylsulfoxoniummethylid in Tetrahydrofuran. Man rührt 1,5 Stunden lang und perlt dann Chlorwasserstoffgas durch die Lösung, bis sich kein Niederschlag mehr bildet. Nach Abfiltrieren und Trocknen des Niederschlags im Vakuum verbleiben 27,5 Teile weißes Pulver das aus Dimethylphenacylsulfoxonium-chlorid (VI, $R^7 = H$, $R^6 = C_6H_4$, p = 1, $R^8 = R^9 = CH_3$, $R^{10} = R^{11} = H$, r = 1, $Z^{r-} = Cl^-$) im Gemisch mit Trimethylsulfoxonium-chlorid besteht.

Dimethylphenacylsulfoxonium-hexafluorophosphat

Eine weitere Probe (27,5 Teile) des wie im vorangehenden Absatz beschrieben erhaltenen Gemischs aus Dimethylphenacylsulfoxonium-chlorid und Trimethylsulfoxonium-chlorid löst man in 150 Teilen Wasser und versetzt unter Rühren mit einer Lösung von 40 Teilen Kaliumhexafluorophosphat in 150 Teilen Wasser. Nach 30 Minuten wird der ausgefallene Feststoff abfiltriert, mit Wasser gewaschen und im Vakuum bei 50° —60° C getrocknet.

Eine Probe (6 Teile) getrockneten Feststoffs extrahiert man mit 20 Teilen Aceton. Beim Eindampfen des Acetons verbleiben 4 Teile des gewünschten, weitgehend von Trimethylsulfoxoniumsalz freien Dimethylphenacylsulfoxonium-hexafluorophosphats (VI, $R^7 = H$, $R^6 = C_6H_4$, p = 1, $R^8 = R^9 = CH_3$, $R^{10} = R^{11} = H$, r = 1, $Z^{r-} = PF_6^-$) als schwach gelber Feststoff vom Schmelzpunkt 161° —3° C. Beim Umkristallisieren aus Methanol erhält man farblose Platten vom Schmelzpunkt 171° C. NMR (Aceton-$d_6$) 4,15 (s-6H), 6,10 (s-2H) und 7,95 (m-5H); IR (KBr-Scheibe 3020, 2690, 2920, 1675, 1590, 1330, 1310, 1230, 1190, 1035, 980 und 840 $cm^{-1}$; UV (Äthanol) $\lambda_{max} = 254$ nm.

Dimethylphenacylsulfoxonium-hexafluorophosphat wird auch hergestellt, indem man 11,4 Teile Benzoylchlorid im Verlauf von 10 Minuten unter Stickstoff zu 300 Teilen einer 0,4-m-Lösung von Dimethylsulfoxonium-methylid in Tetrahydrofuran tropft und wie vorher 1,5 Stunden rührt, dann im Verlauf von 20 Minuten 45 Teile Hexafluorophosphorsäure /Diäthylätherkomplex dazutropft, 1$^1/_2$ Stunden weiterrührt, den Niederschlag abfiltriert und im Vakuum trocknet (wobei man 47 Teile eines Gemischs aus Trimethylsulfoxonium-hexafluorophosphat und Dimethylphenacylsulfoxonium-hexafluorophosphat erhält) und dann die gewünschte Phenacylverbindung wie oben in Aceton extrahiert.

(Diäthylamino)-diphenylsulfoxonium-hexafluorophosphat

S,S-Diphenylsulfoximin wird nach der von S. Oae u. a., Int. J. Sulfur Chem., Teil A, 1972, 2 (1), 49, beschriebenen Methode durch Umsetzung von Diphenylsulfoxyd, Natriumazid und Schwefelsäure in Chloroform hergestellt. Behandlung dieses Sulfoximins mit Triäthyloxonium-hexafluorophosphat auf die von C. R. Johnson u. a., J. Amer. Chem. Soc., 1973, 95, 7692, für die Umsetzung von S-Äthyl-S-p-tolylsulfoximin mit Trimethyloxonium-tetrafluoroborat beschriebene Weise liefert das bisher unbekannte (Diäthylamino)-diphenylsulfoxonium-hexafluorophosphat (VI, $R^7 = H$, $R^6 = C_6H_4$, p = Null, $R^9 = (C_2H_5)_2N$, $R^8 = C_6H_5$, r = 1, $Z^{r-} = PF_6^-$) in 68% Ausbeute nach Umkristallisieren aus einem Gemisch aus Dichlormethan und Diäthyläther. Das Produkt hat einen Schmelzpunkt von 148° —50° C, NMR ($CDCl_3$) 7,7—8,3 (m-10H), 3,50 (q-4H), 1,33 (t-6H).

1,4-Bis-(1-oxo-2-(dimethylsulfoxonium)-äthyl)-benzol-dihexafluoroarsenat

In einer Stickstoffatmophäre tropft man in 18 Teilen Tetrahydrofuran gelöstes Terephthaloylchlorid (8,5 Teile) im Verlauf von 30 Minuten zu 300 Teilen einer 4,0-m-Lösung von Dimethylsulfoxonium-methylid in Tetrahydrofuran. Nach 1,5 Stunden Rühren des Gemischs wird Chlorwasserstoffgas hindurchgeperlt, bis sich kein Niederschlag mehr bildet. Dann wird das Gemisch noch eine Stunde gerührt und

der Feststoff abfiltriert und im Vakuum getrocknet.

Eine Probe dieses Feststoffs (5 Teile) rührt man mit 50 Teilen Wasser und versetzt mit einer Lösung von Kaliumhexafluoroarsenat (15 Teile) in 100 Teilen Wasser. Nach 30 Minuten Rühren wird der Feststoff abfiltriert und anschließend mehrmals aus Methanol umkristallisiert. Dabei erhält man das gewünschte Produkt (VI, $R^7 = p\text{-}COCH_2S^+(CH_3)_2{=}O.AsF_6^-$, $R^6 = C_6H_4$, $p = 1$, $R^8 = R^9 = CH_3$, $R^{10} = R^{11} = H$, $r = 1$, $Z^{r-} = AsF_6^-$), weitgehend frei von Trimethylsulfoxonium-hexafluoroarsenat, als schwach gelbe Kristalle vom Schmelzpunkt 188°—90°C, NMR (Aceton-$d_6$) 4,20 (s-12H), 6,30 (s-4H), 8,32 (s-4H); IR (KBr-Scheibe) 3020, 2930, 1685, 1405, 1310, 1235, 1035, 980, 950 und 700 $cm^{-1}$; UV (Äthanol) $\lambda_{max} = 311$ nm.

Diphenylphenacylsulfoxonium-hexafluorophosphat

Diphenylsulfoxonium-phenacylid wird durch Umsetzung von α-Diazoacetophenon mit Diphenylsulfoxyd in Gegenwart von Kupferacetylacetonat hergestellt, wie von Takebayashi u. a. (Chemistry Letters, 1973, 809) beschrieben. Man leitet Chlorwasserstoffgas durch eine Lösung dieses Ylids in Toluol, bis sich kein Niederschlag mehr bildet. Dieser Niederschlag wird abfiltriert, im Vakuum getrocknet und dann in Wasser aufgelöst. Eine äquimolare Menge einer wäßrigen Kaliumhexafluorophosphat-lösung wird dazugegeben und nach 15 Minuten Rühren wird das ausgefällte Diphenylphenacylsulfoxonium-hexafluorophosphat (VI, $R^7 = H$, $R^6 = C_6H_4$, $p = 1$, $R^8 = R^9 = C_6H_5$, $R^{10} = R^{11} = H$, $r = 1$, $Z^{r-} = PF_6^-$) abgetrennt und im Vakuum getrocknet.

1,4-Bis-(1-oxo-2-(dimethylsulfoxonium)-äthyl)-benzol-dihexafluoroantimonat (Gemisch)

Eine weitere Probe (5 Teile) des wie oben beschrieben hergestellten Gemischs aus 1,4-Bis-(1-oxo-2-(dimethylsulfoxonium)-äthyl)-benzol-dichlorid und Trimethylsulfoxoniumchlorid verrührt man mit 100 Teilen Wasser und versetzt diese Suspension portionsweise mit 19 Teilen Kaliumhexafluoroantimonat. Nach weiteren 30 Minuten Rühren wird das so erhaltene Gemisch aus 1,4-Bis-(1-oxo-2-(dimethylsulfoxonium)-äthyl)-benzol-dihexafluoroantimonat (VI, $R^7 = p\text{-}COCH_2S^+(CH_3)_2{=}O.AsF_6^-$, $R^6 = C_6H_4$, $p = 1$, $R^8 = R^9 = CH_3$, $R^{10} = R^{11} = H$, $r = 1$, $Z^{r-} = SbF_6^-$) und Trimethylsulfoxonium-hexafluoroantimonat abfiltriert und im Vakuum getrocknet.

Dodecylmethylbenzylsulfoxonium-hexafluorophosphat

Dodecylmethylbenzylsulfoxonium-methosulfat wird wie in U.S. Patentschrift Nr. 3 196 184 beschrieben hergestellt. Eine Lösung dieses Salzes in Wasser versetzt man mit einer äquivalenten Menge Kaliumhexafluorophosphat in Wasser. Dabei scheidet sich ein Öl ab, das isoliert und getrocknet wird; laut Infrarotspektroskopie erweist es sich als das gewünschte Hexafluorophosphat (VI, $R^7 = H$, $R^6 = C_6H_4CH_2$, $p$ = Null, $R^8 = C_{12}H_{25}$, $R^9 = CH_3$, $r = 1$, $Z^{r-} = PF_6^-$).

Dimethylphenacylsulfoxonium-hexafluoroantimonat

Eine weitere Probe (5 Teile) des Gemischs aus Dimethylphenacylsulfoxonium-chlorid und Trimethylsulfoxonium-chlorid löst man in 50 Teilen Wasser und versetzt unter Rühren mit 6,7 Teilen Natriumhexafluoroantimonat. Nach 30 Minuten wird der ausgefällte Feststoff abfiltriert, mit Wasser gewaschen und im Vakuum getrocknet. Dabei erhält man 8 Teile eines Gemischs aus Dimethylphenacylsulfoxonium-hexafluoroantimonat (VI, $R^7 = H$, $R^6 = C_6H_4$, $p = 1$, $R^8 = R^9 = CH_3$, $R^{10} = R^{11} = H$, $r = 1$, $Z^{r-} = SbF_6^-$) und Trimethylsulfoxonium-hexafluoroantimonat.

Triphenylsulfoxonium-hexafluorophosphat

Man rührt ein Gemisch aus 157 Teilen Aceton, 4 Teilen Triphenylsulfonium-hexafluorophosphat, 8,48 Teilen Natriumcarbonat und 17,2 Teilen m-Chlorperoxybenzoesäure 24 Stunden bei 20°C. Eine Lösung von 40 Teilen Natriumthiosulfat in 500 Teilen Wasser wird zugesetzt. Man entfernt das Aceton bei vermindertem Druck und filtriert das Triphenylsulfoxonium-hexafluorophosphat ab und trocknet im Vakuum bei 50°C. Das so erhaltene gewünschte Produkt (VI, $R^7 = H$, $R^6 = C_6H_4$, $p$ = Null, $R^8 = R^9 = C_6H_5$, $r = 1$, $Z^{r-} = PF_6^-$) hat einen Schmelzpunkt von 233°—238°C; NMR (Aceton-$d_6$) 7,8—8,3 (m); IR (KBr-Scheibe) 3100, 3070, 1450, 1225, 1080, 840, 760, 730 und 685 $cm^{-1}$; UV (Äthanol) $\lambda_{max}$ 232 nm und 270 nm.

Tris-(dimethylphenacylsulfoxonium)-phosphat

Unter Stickstoff versetzt man eine Lösung von Trimethylsulfoxonium-jodid (14,3 Teile) in Dimethylsulfoxyd (360 Teile) mit 1,95 Teilen Natriumhydrid. Man rührt und gibt nach Aufhören der Wasserstoffentwicklung eine Lösung von Benzorsäureanhydrid (7,6 Teile) in Toluol (20 Teile) dazu. Man rührt das Gemisch noch eine Stunde, filtriert den Feststoff Trimethylsulfoxoniumbenzoat ab und destilliert das Lösungsmittel unter vermindertem Druck aus dem Filtrat ab. Der Rückstand aus dem Filtrat wird viermal mit je 50 Teilen heißem Toluol extrahiert, und dann wird einige Minuten lang Chlorwasserstoffgas in die vereinigten Toluolextrakte eingeleitet. Man gießt das Toluol ab und wäscht den zurückbleibenden Feststoff mit Äther.

Man löst einen Anteil (5,0 Teile) dieses Feststoffes (d. h. Dimethylphenacylsulfoxonium-chlorid) in Wasser (50 Teile) und versetzt mit 2,97 Teilen Silberphosphat. Nach einer Stunde Rühren wird das ausgefällte Silberchlorid abfiltriert und das gewünschte Trisulfoxoniumorthophosphat (VI, $R^7 = H$, $R^6 = C_6H_5$, $p = 1$, $R^8 = R^9 = CH_3$, $R^{10} = R^{11} = H$, $r = 3$, $Z^{r-} = PO_4^{3-}$) durch Abdestillieren des Wassers gewonnen.

Beispiele 1—6

Zusammensetzungen aus Epoxidharzen und Sulfoxoniumsalzen werden hergestellt wie in der nachfolgenden Tabelle angeführt, und als 10 µm dicke Filme auf Weißblech aufgezogen und dann im Abstand von 8 cm der Strahlung einer Mitteldruckquecksilberbogenlampe (80 W pro cm) 5 Sekunden, bzw. 30 Sekunden im Fall von Beispiel 3 und 60 Sekunden, im Beispiel 5, ausgesetzt. Dabei bildet sich in jedem Fall ein harter, klarer Film.

| Beispiel Nr. | Epoxidharz Bezeichnung | Teile | Sulfoxoniumsalz Bezeichnung | Teile |
|---|---|---|---|---|
| 1 | 2,2-Bis-(p-glycidyloxyphenyl)-propan | 98 | Dimethylphenylsulfoxonium-hexafluorophosphat | 2 |
| 2 | 2,2-Bis-(p-glycidyloxyphenyl)-propan | 98 | Dimethylphenacylsulfoxonium-hexafluorophosphat | 2 |
| 3 | 2,2-Bis-(p-glycidyloxyphenyl)-propan | 98 | (Diäthylamino)-diphenylsulfoxonium-hexafluorophosphat | 2 |
| 4 | 2,2-Bis-(p-glycidyloxyphenyl)-propan | 99 | 1,4-Bis-(1-oxo-2-(dimethylsulfoxonium)-äthyl)-benzol-dihexafluoroarsenat | 1 |
| 5 | 2,2-Bis-(p-glycidyloxyphenyl)-propan | 99 | Diphenylphenacylsulfoxonium-hexafluorophosphat | 1 |
| 6 | 3,4-Epoxycyclohexyl-methylester der 3,4-Epoxycyclohexancarbonsäure | 98 | Dimethylphenacylsulfoxonium-hexafluorophosphat | 2 |

Beispiel 7

Ein Gemisch aus zwei Teilen Dimethylphenacylsulfoxonium-hexafluorophosphat und 98 Teilen 3,4-Dihydro-2H-pyranyl-(2)-methylester der 3,4-Dihydro-2H-pyran-2-carbonsäure bestrahlt man als 10 µm dicken Film auf Weißblech 5 Sekunden lang wie in Beispielen 1 bis 6 beschrieben. Man erhält einen klebfreien Überzug.

Beispiel 8

Man verfährt wie in Beispiel 7, unter Verwendung eines handelsüblichen Phenol/Formaldehydresols mit einem P : F-Molverhältnis von 1 : 1,6 anstelle des Vinyläthers. Nach 5 Sekunden Bestrahlung erhält man einen harten, klebfreien Überzug.

Beispiel 9

Man verfährt wie in Beispiel 7, jedoch mit 4 Teilen des wie oben beschrieben hergestellten Gemischs aus Dimethylphenacylsulfoxonium-chlorid und Trimethylsulfoxonium-chlorid sowie unter Verwendung von 96 Teilen eines handelsüblichen Harnstoff/Formaldehydharzes (Gehalt an harzbildenden Feststoffen 70%, H : F-Molverhältnis 1 : 1,8) anstelle des Vinyläthers. Bei 5 Sekunden Bestrahlung erhält man einen klebfreien, lösungsmittelbeständigen Überzug.

Beispiel 10

Man verfährt wie in Beispiel 9, unter Verwendung von 4 Teilen Tris-(dimethylphenacylsulfoxonium)-phosphat als Katalysator. Bei 5 Sekunden Bestrahlung erhält man ebenfalls einen klebfreien Überzug.

Beispiel 11

Man verfährt wie in Beispiel 7, unter Verwendung eines handelsüblichen methylierten Melamin/Formaldehydharzes (im wesentlichen Hexa-(methoxymethyl)-melamin) anstelle des Vinyläthers. Nach 5 Sekunden Bestrahlung des Films wird die Härtung durch 15 Minuten Erhitzen auf 120° C vervollständigt. Man erhält einen harten, lösungsmittelbeständigen Überzug.

Beispiel 12

Einen Teil der in Beispiel 4 hergestellten Zusammensetzung trägt man als 10 µm dicke Schicht auf eine 1 mm dicke Glasplatte auf, legt eine ähnliche Glasplatte darüber und bestrahlt den Aufbau mit einer Mitteldruckquecksilberbogenlampe bei 80 W pro cm. Nach 30 Sekunden Belichtung sind die Glasplatten bleibend verklebt.

Beispiel 13

Man mischt einen Teil des wie oben beschrieben hergestellten Gemischs aus 1,4-Bis-(1-oxo-2-(dimethylsulfoxonium)-äthyl)-benzol-dihexafluoroantimonat und Trimethylsulfoxonium-hexafluoroantimonat mit 99 Teilen 2,2-Bis-(p-glycidyloxyphenyl)-propan und bestrahlt diese Zusammensetzung als 10 µm dicke Schicht auf Weißblech 10 Sekunden lang wie in Beispielen 1 bis 6 beschrieben. Man erhält einen harten klebfreien Überzug.

Beispiel 14

Man vermischt Dodecylmethylbenzylsulfoxonium-hexafluorophosphat (2 Teile) mit 98 Teilen 2,2-Bis-(p-glycidyloxyphenyl)-propan und bestrahlt eine 10 µm dicke Schicht dieses Gemischs auf Weißblech 30 Sekunden lang, wie in Beispielen 1 bis 6 beschrieben. Man erhält einen klebfreien Überzug.

Beispiel 15

Man mischt zwei Teile des Gemischs aus Dimethylphenacylsulfoxonium-hexafluoroantimonat und Trimethylsulfoxonium-hexafluoroantimonat mit 98 Teilen 2,2-Bis-(p-glycidyloxyphenyl)-propan und bestrahlt diese Zusammensetzung wie in Beispielen 1 bis 6. Innerhalb 10 Sekunden erhält man einen klebfreien Überzug.

Beispiel 16

Man trägt ein Gemisch aus 2,2-Bis-(p-glycidyloxyphenyl)-propan (10 Teile), $\gamma$-Butyrolacton (0,2 Teil) und Triphenylsulfoxonium-hexafluorophosphat (0,1 Teil) auf Weißblech auf und bestrahlt 12 Sekunden wie in Beispielen 1 bis 6 beschrieben. So erhält man einen klaren, harten, klebfreien Überzug.

Beispiel 17

Man verfährt wie in Beispiel 16, unter Verwendung des 3,4-Epoxycyclohexylmethylesters der 3,4-Epoxycyclohexancarbonsäure als Epoxidharz und 0,2 Teil Triphenylsulfoxonium-hexafluorophosphat. Bei 4 Sekunden Bestrahlung erhält man einen klaren, harten, klebfreien Überzug.

Beispiel18

Dieses Beispiel erläutert die Kombinationshärtung mit einem mehrwertigen Alkohol.

Man bringt eine aus 100 Teilen des 3,4-Epoxycyclohexyl-methylesters der 3,4-Epoxycyclohexancarbonsäure, 75 Teilen eines handelsüblichen Styrol/Allylalkoholcopolymeren (Hydroxylgehalt 3,56 val/kg) und 1,5 Teilen 1,4-Bis-(1-oxo-2-(dimethylsulfoxonium)-äthyl)-benzol-dihexafluoroarsenat bestehende Zusammensetzung als 10 µm dicke Beschichtung auf Weißblech auf und belichtet dann mit der Strahlung einer Mitteldruckquecksilberbogenlampe. Ein lösungsmittelbeständiger Überzug bildet sich in 10 Sekunden.

Beispiel 19

Dieses Beispiel erläutert ein zweistufiges Verfahren, bei dem zunächst eine Epoxidharzzusammensetzung photopolymerisiert und danach durch den ebenfalls in der Zusammensetzung enthaltenen latenten Heißhärtungskatalysator beim Erhitzen vernetzt wird.

Eine flüssige Zusammensetzung, die 75 Teile Diglycidyläther des 2,2-Bis-(p-hydroxyphenyl)-propans (Epoxidgehalt 5,1 val/kg), 25 Teile eines Polyglycidyläthers (Epoxidgehalt 5,6 val/kg) eines Phenol/Formaldehyd-novolaks, 4 Teile Bortrichlorid/Trimethylaminkomplexe und 2 Teile Dimethylphenacylsulfoxonium-hexafluorophosphat enthält, wird zum Imprägnieren von Glastuch verwendet, und das imprägnierte Tuch wird auf beiden Seiten 10 Sekunden im Abstand von 8 cm mit der Strahlung einer Mitteldruckbogenlampe 80 W pro cm belichtet. Durch eine Stunde Verpressen von quadratischen (10 cm Seitenlänge) Stücken des Prepregs bei 200° C unter einem Druck von 1,05 $MN/m^2$ stellt man einen Sechsfachschichtkörper her. Dieser aus 62% Glas bestehende Schichtkörper besitzt eine Biegefestigkeit von 406 $MN/m^2$.

Beispiel 20

Dieses Beispiel erläutert die Verwendung eines Sensibilisators.

Man bringt einen Anteil einer aus 2 Teilen 1,4-Bis-(1-oxo-2-(dimethylsulfoxonium)-äthyl)-benzol-dihexafluoroarsenat und 98 Teilen 2,2-Bis-(p-glycidyloxyphenyl)-propan bestehenden Zusammensetzung als 10 µm-Film auf Weißblech auf. Die Schicht wird mit der Strahlung einer 400 W Hochdruckmetallhalogenid-Quarzlampe im Abstand von 22 cm belichtet. Nach 2,5 Minuten Belichtung entsteht ein klebfreier Film. Einem weiteren Anteil des obigen Gemischs wird 0,6% Pyren beigemischt. Belichtung dieses Gemischs als 10 µm-Film unter denselben Bestrahlungsbedingungen wie für Gemische ohne Pyren ergibt einen klebfreien Überzug nach $1^1/_4$ Minuten Bestrahlung. Dieser Film ist mit Aceton nicht entfernbar.

Beispiel 21

Dieses Beispiel erläutert die Herstellung eines Photoresists.

Man bereitet eine Lösung von 1 g Diglycidyläther des 2,2-Bis-(4-hydroxyphenyl)-propans, 4 g Tetraglycidyläther des 1,1,2,2-Tetra-(4-hydroxyphenyl)-äthans, 5 g Diglycidyläther des 2,2-Bis-(4-hydroxyphenyl)-propans, der mit einem bromhaltigen Phenol auf einen Erweichungspunkt von 50° C vorverlängert ist und einen Epoxidgehalt von 2 val/kg aufweist, und 0,2 g Dimethylphenacylsulfoxonium-hexafluorophosphat in 10 g Cyclohexanon. Man beschichtet kupferkaschiertes Plattenmaterial mit dieser Zusammensetzung und läßt das Lösungsmittel verdunsten, wobei ein etwa 10µm dicker Film verbleibt. Dieser wird unter Verwendung einer 500 W Mitteldruckquecksilberlampe im Abstand von 22 cm durch ein Negativ hindurch 10 Minuten lang bestrahlt. Nach der Bestrahlung wird das Bild in Toluol entwikkelt, wobei die unbelichteten Stellen ausgewaschen werden; auf dem Kupfer verbleibt ein gutes Reliefbild. Die unbeschichteten Stellen werden dann mit einer wäßrigen Eisen-III-chloridlösung (41 Gew.-% $FeCl_3$) bei 35° C geätzt, wobei die beschichteten Stellen nicht angegriffen werden.

**Patentansprüche**

1. Zusammensetzungen, gekennzeichnet durch

(a) eine Verbindung bzw. ein Gemisch von Verbindungen, die unter dem Einfluß eines kationischen Katalysators in höhermolekulares Material überführbar sind, und
(b) eine katalytische Menge eines Sulfoxoniumsalzes der Formel

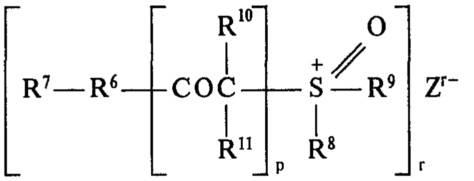

(VI)

worin p Null oder 1 bedeutet, $R^6$ eine Arylen- oder Aralkylengruppe mit 4 bis 25 Kohlenstoffatomen, die bei p = Null über eines ihrer Kohlenstoffatome direkt an das angegebene Schwefelatom oder bei p = 1 an das angegebene Carbonylkohlenstoffatom gebunden ist, darstellt, $R^7$ für ein Wasserstoffatom oder eine Gruppe der Formel

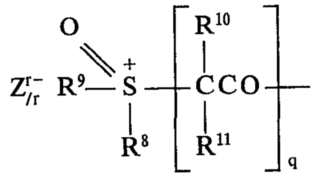

(VII)

steht, $R^8$ eine Alkylgruppe mit 1 bis 18 Kohlenstoffatomen, eine Alkenylgruppe mit 2 bis 6 Kohlenstoffatomen, eine Cycloalkylgruppe mit 3 bis 6 Kohlenstoffatomen, eine Cycloalkylalkylgruppe mit 4 bis 8 Kohlenstoffatomen, eine Arylgruppe mit 4 bis 24 Kohlenstoffatomen oder eine Aralkylgruppe mit 5 bis 16 Kohlenstoffatomen bedeutet, $R^9$ dieselbe Bedeutung wie $R^8$ hat, aber auch für eine Dialkylaminogruppe mit 2 bis 6 Kohlenstoffatomen oder, falls $R^8$ eine besagte Alkylgruppe darstellt, auch für eine Arylaminogruppe mit 4 bis 8 Kohlenstoffatomen stehen kann, $R^{10}$ und $R^{11}$ unabhängig voneinander dieselbe Bedeutung wie $R^8$ haben, aber auch je für Wasserstoff stehen können, r 1, 2 oder 3 ist, $Z^{r-}$ ein r-wertiges Anion einer Protonensäure bedeutet und q bei p = Null für Null bzw. bei p = 1 für Null oder 1 steht.

2. Zusammensetzungen nach Anspruch 1, dadurch gekennzeichnet, daß $R^6$ eine homocyclische Arylen- oder Aralkylengruppe mit 6 bis 11 Kohlenstoffatomen darstellt.

3. Zusammensetzungen nach Anspruch 1, dadurch gekennzeichnet, daß $R^8$ und $R^9$ je eine Alkylgruppe mit 1 bis 12 Kohlenstoffatomen bedeuten.

4. Zusammensetzungen nach Anspruch 1, dadurch gekennzeichnet, daß $R^8$ und $R^9$ je eine Alkylgruppe mit 1 bis 4 Kohlenstoffatomen oder eine gegebenenfalls in dem bzw. den Ringen durch eine oder zwei Alkylgruppen mit je 1 bis 4 Kohlenstoffatomen, eine oder zwei Alkoxygruppen mit je 1 bis 4 Kohlenstoffatomen oder ein oder zwei Fluor-, Chlor- oder Bromatome substituierte Phenyl- oder Naphtylgruppe bedeutet.

5. Zusammensetzungen nach Anspruch 1, dadurch gekennzeichnet, daß $Z^{r-}$ für $Cl^-$, $Br^-$, $NO_3^-$, $HSO_4^-$, $HSO_3^-$, $ClO_4^-$, $H_2PO_4^-$, $SO_4^{--}$, $PO_4^{---}$ oder ein Anion der Formel

$$MX_n^- \qquad IX$$

worin M für ein Bor-, Wismut-, Antimon-, Arsen- oder Phosphoratom steht, X ein Fluor- oder Chloratom darstellt und n 4, 5 oder 6 und um eins höher als die Wertigkeit von M ist, steht.

6. Zusammensetzungen nach Anspruch 1, dadurch gekennzeichnet, daß als (b)
Dimethylphenylsulfoxonium-hexafluorophosphat,
Dimethylphenacylsulfoxonium-hexafluorophosphat,
Dimethylphenacylsulfoxonium-hexafluoroantimonat,
Diphenylphenacylsulfoxonium-hexafluorophosphat,
1,4-Bis-(1-oxo-2-(dimethylsulfoxonium)-äthyl)-benzol-dihexafluoroarsenat,
(Dimethylamino)-diphenylsulfoxonium-tetrafluoroborat,
(Diäthylamino)-diphenylsulfoxonium-hexafluorophosphat,
1,4-Bis-(1-oxo-2-(dimethylsulfoxonium)-äthyl)-benzol-dihexafluoroantimonat,
Dodecylmethylbenzylsulfoxonium-hexafluorophosphat,
Triphenylsulfoxonium-hexafluorophosphat, Dimethylphenylsulfoxonium-perchlorat,
Dimethylphenacylsulfoxonium-chlorid,
1,4-Bis-(1-oxo-2-(dimethylsulfoxonium)-äthyl)-benzol-dichlorid oder
Tris-(dimethylphenacylsulfoxonium)-phosphat
vorliegt.

7. Zusammensetzungen nach Anspruch 1, dadurch gekennzeichnet, daß als (a) ein 1,2-Epoxid, ein Vinylmonomer oder -präpolymer, ein Aminoplast oder ein Phenoplast vorliegt, wobei im Falle eines 1,2-Epoxides $Z^-$ in der Formel VI und falls vorhanden in der Formel VII für eine Gruppe $MX_n^-$ oder $SbF_5(OH)^-$ steht.

8. Zusammensetzungen nach Anspruch 7, dadurch gekennzeichnet, daß als (a) ein Epoxidharz oder ein aus einem Phenol und einem Aldehyd hergestelltes Resolharz vorliegt.

9. Zusammensetzungen nach Anspruch 1, dadurch gekennzeichnet, daß sie 0,1 bis 7,5 Gewichtsteile (b) auf 100 Gewichtsteile (a) enthalten.

10. Zusammensetzungen nach Anspruch 8, dadurch gekennzeichnet, daß sie ferner eine härtende Menge eines latenten Heißhärters für das Epoxidharz bzw. Resolharz enthalten.

**Claims**

1. Compositions, characterised by

(a) a compound, or a mixture of compounds, capable of being converted into a higher-molecular weight material under the influence of a cationic catalyst, and
(b) a catalytic amount of a sulfoxonium salt of the formula

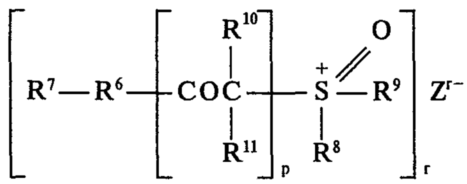
(VI)

wherein p is zero or 1, $R^6$ is an arylene or aralkylene group having 4 to 25 carbon atoms which is linked directly through a carbon atom thereof to, if p is zero, the indicated sulfur atom or, if p is 1, to the indicated carbonyl carbon atom, $R^7$ is a hydrogen atom or a group of the formula

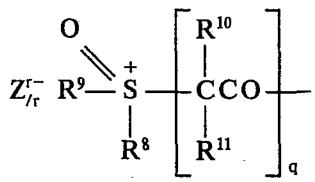
(VII)

$R^8$ is an alkyl group having 1 to 18 carbon atoms, an alkenyl group having 2 to 6 carbon atoms, a cycloalkyl group having 3 to 6 carbon atoms, a cycloalkylalkyl group having 4 to 8 carbon atoms, an aryl group having 4 to 24 carbon atoms or an aralkyl group having 5 to 16 carbon atoms, $R^9$ has the same meaning as $R^8$ or is a dialkylamino group having 2 to 6 carbon atoms or, if $R^8$ is a said alkyl group, is an arylamino group having 4 to 8 carbon atoms, $R^{10}$ and $R^{11}$ independently of one another each have the same meaning as $R^8$, or can each be hydrogen, r is 1, 2 or 3, $Z^{r-}$ is an r-valent anion of a protic acid, and q is zero when p is zero, or is zero or 1 when p is 1.

2. Compositions according to claim 1, characterised in that $R^6$ is a homocyclic arylene or aralkylene group having 6 to 11 carbon atoms.

3. Compositions according to claim 1, characterised in that $R^8$ and $R^9$ are each an alkyl group having 1 to 12 carbon atoms.

4. Compositions according to claim 1, characterised in that $R^8$ and $R^9$ are each an alkyl group having 1 to 4 carbon atoms, or a phenyl or naphthyl group, which is unsubstituted or substituted in the ring(s) by one or two alkyl groups each having 1 to 4 carbon atoms, by one or two alkoxy groups each having 1 to 4 carbon atoms, or by one or two fluorine, chlorine or bromine atoms.

5. Compositions according to claim 1, characterised in that $Z^{r-}$ is $Cl^-$, $Br^-$, $NO_3^-$, $HSO_4^-$, $HSO_3^-$, $ClO_4^-$, $H_2PO_4^-$, $SO_4^{--}$, $PO_4^{---}$, or an anion of the formula

$$MX_n^- \qquad (IX)$$

wherein M is a boron, bismuth, antimony, arsenic or phosphorus atom, X is a fluorine or chlorine atom, and n is 4, 5 or 6 and is one more than the valency of M.

6. Compositions according to claim 1, characterised in that (b) is

dimethylphenylsulfoxonium hexafluorophosphate,
dimethylphenacylsulfoxonium hexafluorophosphate,
dimethylphenacylsulfoxonium hexafluoroantimonate,
diphenylphenacylsulfoxonium hexafluorophosphate,

1,4-bis(1-oxo-2-(dimethylsulfoxonium)-ethyl)benzene dihexafluoroarsenate,
(dimethylamino)diphenylsulfoxonium tetrafluoroborate,
(diethylamino)diphenylsulfoxonium hexafluorophosphate,
1,4-bis(1-oxo-2-(dimethylsulfoxonium)ethyl)benzene dihexafluoroantimonate,
dodecylmethylbenzylsulfoxonium hexafluorophosphate,
triphenylsulfoxonium hexafluorophosphate, dimethylphenylsulfoxonium perchlorate,
dimethylphenacylsulfoxonium chloride,
1,4-bis(1-oxo-2-(dimethylsulfoxonium)-ethyl)benzene dichloride or
tris(dimethylphenacylsulfoxonium) phosphate.

7. Compositions according to claim 1, characterised in that (a) is a 1,2-epoxide, a vinyl monomer or prepolymer, an aminoplast or a phenoplast, where, in the case of a 1,2-epoxide, $Z^-$ in the formula VI and, if present, in the formula VII is a group $MX_n^-$ or $SbF_5(OH)^-$.

8. Compositions according to claim 7, characterised in that (a) is an epoxide resin, or a resol resin produced from a phenol and an aldehyde.

9. Compositions according to claim 1, characterised in that they contain 0.1 to 7.5 parts by weight of (b) to 100 parts by weight of (a).

10. Compositions according to claim 8, characterised in that they also contain a curing amount of a latent heat-curing agent for the epoxide resin or for the resol resin.

**Revendications**

1. Compositions caractérisées par:

(a) un composé ou un mélange de composés qui, sous l'influence d'un catalyseur cationique, sont convertibles en produits à plus hauts poids moléculaires, et
(b) une quantité catalytique d'un sel de sulfoxonium répondant à la formule (VI):

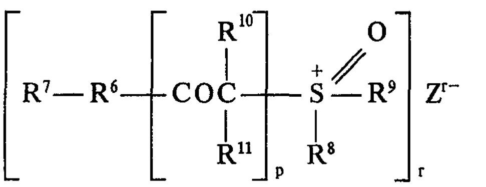
(VI)

dans laquelle:

p représente le nombre 0 ou le nombre 1,
$R^6$ représente un radical arylène ou aralkylène contenant de 4 à 25 atomes de carbone, radical qui est uni, par l'un de ses atomes de carbone, directement à l'atome de soufre représenté dans le cas où p est égal à 0 ou à l'atome de carbone carbonylique représenté dans le cas où p est égal à 1,
$R^7$ représente un atome d'hydrogène ou un radical de formule (VII]:

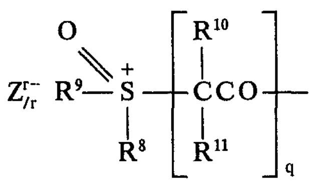
(VII)

$R^8$ représente un radical alkyle contenant de 1 à 18 atomes de carbone, un radical alcényle contenant de 2 à 6 atomes de carbone, un radical cycloalkyle contenant de 3 à 6 atomes, un radical cycloalkyl-alkyle contenant de 4 à 8 atomes de carbone, un radical aryle contenant de 4 à 24 atomes de carbone, ou un radical aralkyle contenant de 5 à 16 atomes de carbone,
$R^9$ a la même signification que $R^8$ mais peut aussi représenter un radical dialkylamino contenant de 2 à 6 atomes de carbone ou, dans le cas où $R^8$ désigne l'un des radicaux alkyles mentionnés, $R^9$ peut également être un radical arylamino contenant de 4 à 8 atomes de carbone,
$R^{10}$ et $R^{11}$ont chacun, indépendamment l'un de l'autre, la même signification que $R^8$ mais peuvent aussi représenter chacun un atome d'hydrogène,
r est égal à 1, à 2 ou à 3,
$Z^{r-}$ représente un anion de valence r provenant d'un acide protonique, et
q est égal à 0 lorsque p est égal à 0, ou est égal à 0 ou à 1 lorsque p est égal à 1.

2. Compositions selon la revendication 1 caractérisées en ce que $R^6$ représente un radical arylène ou aralkylène homocyclique qui contient de 6 à 11 atomes de carbone.

3. Compositions selon la revendication 1 caractérisées en ce que $R^8$ et $R^9$ représentent chacun un

radical alkyle contenant de 1 à 12 atomes de carbone.

4. Compositions selon la revendication 1 caractérisées en ce que $R^8$ et $R^9$ représentent chacun un radical alkyle contenant de 1 à 4 atomes de carbone, ou un radical phényle ou naphtyle portant éventuellement, sur son cycle ou sur ses cycles, un ou deux radicaux alkyles contenant chacun de 1 à 4 atomes de carbone, un ou deux radicaux alcoxy contenant chacun de 1 à 4 atomes de carbone, ou un ou deux atomes de fluor, de chlore ou de brome.

5. Compositions selon la revendication 1 caractérisées en ce que $Z^{r-}$ représente $Cl^-$, $Br^-$, $NO_3^-$, $HSO_4^-$, $ClO_4^-$, $H_2PO_4^-$, $SO_4^{--}$, $PO_4^{---}$, ou un anion répondant à la formule (IX):

$$MX_n^- \qquad (IX)$$

dans laquelle M représente un atome de bore, de bismuth, d'antimoine, d'arsenic ou de phosphore, X représente un atome de flour ou de chlore, et n est égal à 4, à 5 ou à 6 et est supérieur d'une unité à la valence de M.

6. Compositions selon la revendication 1 caractérisées en ce que leur composante (b) est

l'hexafluorophosphate de diméthyl-phényl-sulfoxonium,
l'hexafluorophosphate de diméthyl-phénacyl-sulfoxonium,
l'hexafluoro-antimoniate de diméthyl-phénacyl-sulfoxonium,
l'hexafluorophosphate de diphényl-phénacyl-sulfoxonium,
le bis-(hexafluoro-arséniate) de bis-[oxo-1 (diméthylsulfoxonium)-2 éthyl]-1,4 benzène,
le tétrafluoroborate de (diméthylamino)-diphényl-sulfoxonium,
l'hexafluorophosphate de (diéthylamino)-diphényl-sulfoxonium,
le bis-(hexafluoro-antimoniate) de
bis-[oxo-1 (diméthyl-sulfoxonium)-2 éthyl]-1,4 benzène,
l'hexafluorophosphate dodécyl-méthyl-benzyl-sulfoxonium,
l'hexafluorophosphate de triphényl-sulfoxonium,
le perchlorate de diméthyl-phényl-sulfoxonium,
le chlorure de diméthyl-phénacyl-sulfoxonium,
le dichlorure de bis-[oxo-1-(diméthyl-sulfoxonium)-2 éthyl]-1,4 benzène ou
le phosphate de tris-(diméthyl-phénacyl-sulfoxonium).

7. Compositions selon la revendication 1, caractérisées en ce que leur composante (a) est un époxyde-1,2, un monomère ou prépolymère vonylique, un aminoplaste ou un phénoplaste, le symbole $Z^-$ présent dans la formule (VI), et, le cas échéant, dans la formule (VII), représentant, dans le cas d'un époxyde-1,2, un radical $MX_n^-$ ou $SbF_5(OH)^-$.

8. Compositions selon la revendication 7 caractérisées en ce que leur composante (a) est une résine époxydique ou un résol préparé à partir d'un phénol et d'un aldéhyde.

9. Compositions suivant la revendication 1 caractérisées en ce qu'elles contiennent de 0,1 à 7,5 parties en poids de (b) pour 100 parties en poids de (a).

10. Compositions selon la revendication 8 caractérisées en ce qu'elles contiennent en outre une quantité apte à durcir d'un thermodurcisseur latent pour la résine époxydique ou le résol.